(19) **Europäisches Patentamt European Patent Office Office européen des brevets**

(11) **EP 4 464 655 B1**

(12) **FASCICULE DE BREVET EUROPEEN**

(45) Date de publication et mention de la délivrance du brevet:
**24.12.2025 Bulletin 2025/52**

(21) Numéro de dépôt: **23220621.9**

(22) Date de dépôt: **28.12.2023**

(51) Classification Internationale des Brevets (IPC):
**B81B 3/00** *(2006.01)* **B81B 5/00** *(2006.01)*

(52) Classification Coopérative des Brevets (CPC):
**B81B 3/0086; B81B 3/0027; B81B 3/0094; B81B 3/0097; B81B 5/00**

(54) **SYSTEME ÉLECTROMÉCANIQUE COMPRENANT DES MOYENS CAPACITIFS DE MESURE OU D'ACTIONNEMENT ET UN ARBRE DE TRANSMISSION**

ELEKTROMECHANISCHES SYSTEM MIT KAPAZITIVEN MESS- ODER BETÄTIGUNGSMITTELN UND EINER ANTRIEBSWELLE

ELECTROMECHANICAL SYSTEM COMPRISING CAPACITIVE MEASURING OR ACTUATING MEANS AND A TRANSMISSION SHAFT

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **30.12.2022 FR 2214688**

(43) Date de publication de la demande:
**20.11.2024 Bulletin 2024/47**

(73) Titulaire: **Commissariat à l'Energie Atomique et aux Energies Alternatives 75015 Paris (FR)**

(72) Inventeurs:
• **JOET, Loïc 38054 GRENOBLE CEDEX 09 (FR)**
• **DAGHER, Samer 38054 GRENOBLE CEDEX 09 (FR)**

(74) Mandataire: **Cabinet Camus Lebkiri 25 rue de Maubeuge 75009 Paris (FR)**

(56) Documents cités:
**WO-A2-2008/078182**

**Description**

**DOMAINE TECHNIQUE DE L'INVENTION**

Le domaine technique de l'invention est celui des systèmes électromécaniques, notamment de type microsystème électromécanique (MEMS, pour « microelectromechanical systems » en anglais) ou nanosystème électromécanique (NEMS, pour « nanoelectromechanical system »). L'invention concerne plus particulièrement un système électromécanique comprenant un élément mobile, des moyens capacitifs de mesure ou d'actionnement et un dispositif de transmission d'un mouvement entre l'élément mobile et les moyens capacitifs de mesure ou d'actionnement. Un tel système peut être employé en tant que transducteur électroacoustique (ex. microphone, haut-parleur...) ou capteur de pression différentielle.

**ARRIERE-PLAN TECHNOLOGIQUE DE L'INVENTION**

Les microphones en microélectromécanique ou nanoélectromécanique représentent un marché en pleine expansion, notamment grâce au développement des appareils nomades, tels que les tablettes, téléphones portables intelligents (smartphones) et aux autres objets connectés, dans lesquels ils remplacent peu à peu les microphones à électret. Il existe également des systèmes électromécaniques de type micromiroir tel que celui décrit dans le document WO2008/078182.

Les microphones mesurent une variation rapide de la pression atmosphérique, aussi appelée pression acoustique. Ils comportent donc au moins une partie en contact avec l'extérieur.

La plupart des microphones MEMS ou NEMS fabriqués actuellement sont des microphones à détection capacitive. La figure 1 représente un exemple de microphone à détection capacitive 1, décrit dans le brevet FR3114584B1.

Le microphone 1 comprend un bâti (non représenté) délimitant au moins en partie une première zone 11 et une deuxième zone 12, un élément mobile 13 par rapport au bâti et un dispositif de transmission 14 d'un mouvement entre la première zone 11 et la deuxième zone 12. Les première et deuxième zones 11-12 du microphone 1 sont isolées l'une de l'autre de manière étanche.

L'élément mobile 13, aussi appelé piston, est en contact avec la première zone 11. Il comprend une membrane 131 et une structure de rigidification 132 de la membrane. La membrane 131 du piston 13 a pour rôle de récolter sur toute sa surface une différence de pression entre ses deux faces, pour en déduire une variation de la pression atmosphérique. Une face de la membrane 131 est soumise à la pression atmosphérique (dont on souhaite détecter la variation) et une face opposée de la membrane 131 est soumise à une pression de référence.

En outre, le microphone 1 comprend des moyens de détection capacitive 15 disposés dans la deuxième zone 12. Ces moyens de détection capacitive 15 permettent de mesurer le déplacement du piston 13, et donc la différence de pression entre ses deux faces. Ils comprennent de préférence une électrode mobile 151 et au moins une électrode fixe disposée en regard de l'électrode mobile 151. Les électrodes forment les armatures d'un condensateur dont la capacité varie en fonction du déplacement du piston 13.

Le dispositif de transmission 14 est monté mobile en rotation par rapport au bâti, au moyen de plusieurs articulations pivot 16. Le dispositif de transmission 14 comprend deux premiers bras de transmission 141 s'étendant dans la première zone 11, deux deuxièmes bras de transmission 142 s'étendant dans la deuxième zone 12 et deux arbres de transmission 143 s'étendant en partie dans la première zone 11 et en partie dans la deuxième zone 12. Chaque arbre de transmission 143 relie un premier bras de transmission 141 à un deuxième bras de transmission 142.

Chaque premier bras de transmission 141 comprend une première extrémité couplée au piston 13 et une deuxième extrémité opposée, couplée à l'arbre de transmission 143 associé. Chaque deuxième bras de transmission 142 comprend une première extrémité couplée à l'électrode mobile 151 des moyens de détection capacitive 15 et une deuxième extrémité opposée, couplée à l'arbre de transmission 143 associé.

Le brevet FR3059659B1 décrit un microphone à détection capacitive semblable à celui de la figure 1. Les moyens de détection capacitive comprennent une électrode mobile et deux électrodes fixes entre lesquelles est disposée l'électrode mobile. Les électrodes forment les armatures de deux condensateurs dont les capacités varient dans des sens opposés en fonction du déplacement du piston. La mesure du déplacement du piston est alors une mesure différentielle.

Pour réaliser une telle mesure différentielle, les condensateurs sont au préalable chargés en appliquant une tension de polarisation continue entre l'électrode mobile et les électrodes fixes par l'intermédiaire d'une forte résistance. Le déplacement du piston se traduit par une variation des capacités, et donc une variation de la tension entre les électrodes fixes (la charge des condensateurs étant sensiblement constante aux fréquences audibles, typiquement supérieures à 100 Hz) qui peut être lue par un amplificateur d'instrumentation.

Un inconvénient de ces microphones à détection capacitive est que de l'énergie est perdue dans la déformation du dispositif de transmission 14 et du cadre de l'électrode mobile 151, ce qui représente une perte de signal utile lors de la détection des variations dynamiques de pression.

En outre, ces microphones à détection capacitive peuvent devenir défaillants à cause d'un phénomène d'effondrement de l'électrode mobile, appelé « pull-in » en anglais et commun à tous les systèmes électromécaniques comprenant des moyens capacitifs de mesure ou d'actionnement. Ce phénomène d'effondrement est causé par la force électrostatique, qui tend à rapprocher l'électrode mobile de l'électrode fixe (ou de l'une des électrode fixes) et qui dépend du carré de la tension de polarisation. La force électrostatique, qui dépend aussi du déplacement de l'électrode mobile, peut être approximée au premier ordre par une force constante plus la force exercée par un ressort de raideur négative pour de petits déplacements.

Pour éviter (jusqu'à un certain point) ce phénomène d'effondrement, une force élastique est opposée à la force électrostatique. Cette force élastique peut être générée par des ressorts reliant le cadre de l'électrode mobile 151 au bâti du microphone 1. Plus la raideur des ressorts est importante, plus la valeur de tension à laquelle la force électrostatique surpasse la force élastique (tension dite d'effondrement ou « pull-in voltage » en anglais) est importante et plus l'électrode mobile 151 peut être polarisée à une tension élevée. Ceci est avantageux car la sensibilité du microphone 1 augmente avec la tension de polarisation.

La sensibilité du microphone 1 augmente en outre avec le déplacement de l'électrode mobile 151. Une solution pour augmenter le déplacement de l'électrode mobile 151 consisterait à augmenter le déplacement du piston 13 (aussi appelé compliance) mais celui-ci est limité par la fréquence de résonance du microphone 1 (qu'on souhaite au moins égale à 35 kHz). Une autre solution consiste à réduire la longueur des premiers bras de transmission 141 et/ou augmenter la longueur des deuxièmes bras de transmission 142, augmentant ainsi l'effet bras de levier. Il est toutefois difficile de réduire la longueur des premiers bras de transmission 141, parce qu'il existe une zone de scellement autour des moyens de détection capacitive 15 pour les enfermer dans la deuxième zone 12 et parce que cela supposerait de réduire la surface du piston 13. L'augmentation de la longueur des deuxièmes bras de transmission 142 est plus aisée, mais augmente considérablement l'encombrement du microphone. En outre, augmenter simplement la longueur des deuxièmes bras de transmission 142 les rend plus facilement déformables, ce qui réduit finalement le déplacement de l'électrode mobile et diminue la sensibilité.

## RESUME DE L'INVENTION

On constate qu'il existe un besoin de prévoir un système électromécanique à détection capacitive ou actionnement capacitif qui soit à la fois compact et présente une sensibilité élevée.

Selon l'invention, on tend à satisfaire ce besoin en prévoyant un système électromécanique comprenant :

- un bâti ;

- un élément mobile par rapport au bâti ;

- des moyens capacitifs de mesure ou d'actionnement comprenant :

  - une première électrode mobile par rapport au bâti ; et

  - au moins une électrode fixe par rapport au bâti et séparée de la première électrode mobile par un premier milieu diélectrique ;

- un premier dispositif de transmission d'un mouvement entre l'élément mobile et la première électrode mobile, le premier dispositif de transmission étant mobile en rotation par rapport au bâti au moyen d'une pluralité de premières articulations pivot ;

  le premier dispositif de transmission comprenant :

  - un premier arbre de transmission présentant un premier axe longitudinal de rotation ; et

  - une pluralité de premiers bras de transmission, chacun des premiers bras de transmission comprenant une première extrémité couplée à une première moitié de l'élément mobile et une deuxième extrémité solidaire du premier arbre de transmission ;

  la première électrode mobile étant reliée au premier arbre de transmission.

Ainsi, lorsque l'élément mobile se déplace, il entraîne en rotation le premier dispositif de transmission autour du premier axe longitudinal qui lui-même met en mouvement la première électrode mobile. Ce montage permet d'obtenir un plus grand déplacement de l'électrode mobile pour un déplacement de l'élément mobile donné, sans toutefois augmenter l'encombrement du système électromécanique, car le déplacement de l'électrode mobile est désormais décorrélé de la distance entre l'élément mobile et l'électrode mobile. Il dépend désormais de la distance entre la première extrémité des premiers bras de transmission et le premier axe longitudinal de rotation. Le système électromécanique selon l'invention présente ainsi un meilleur compromis entre sensibilité et compacité que le microphone de l'art antérieur.

Avantageusement, la première électrode mobile est solidaire du premier arbre de transmission, d'où il résulte que la première électrode mobile est montée mobile en rotation autour du premier axe longitudinal de rotation.

Dans un mode de réalisation préférentiel :

- les moyens capacitifs de mesure ou d'actionnement comprennent en outre :

    - une deuxième électrode mobile par rapport au bâti ; et

    - au moins une électrode additionnelle fixe par rapport au bâti et séparée de la deuxième électrode mobile par un deuxième milieu diélectrique ;

- le système comprend en outre un deuxième dispositif de transmission d'un mouvement entre l'élément mobile et la deuxième électrode mobile, le deuxième dispositif de transmission étant mobile en rotation par rapport au bâti au moyen d'une pluralité de deuxièmes articulations pivot et comprenant :

    - un deuxième arbre de transmission présentant un deuxième axe longitudinal de rotation ; et

    - une pluralité de deuxièmes bras de transmission, chacun des deuxièmes bras de transmission comprenant une première extrémité couplée à l'élément mobile et une deuxième extrémité solidaire du deuxième arbre de transmission ;

- la deuxième électrode mobile est reliée au deuxième arbre de transmission.

Selon un développement de ce mode de réalisation préférentiel, la deuxième électrode mobile est solidaire du deuxième arbre de transmission, d'où il résulte que la deuxième électrode mobile est montée mobile en rotation autour du deuxième axe longitudinal de rotation.

Selon un autre développement compatible avec le précédent, le premier axe longitudinal de rotation est parallèle au deuxième axe longitudinal de rotation.

Selon un autre développement compatible avec les précédents, la première extrémité des premiers bras de transmission est couplée à une première moitié de l'élément mobile et la première extrémité des deuxièmes bras de transmission est couplée à une deuxième moitié de l'élément mobile.

De préférence, l'élément mobile est en contact avec une première zone et les première et deuxième électrodes mobiles sont situées dans une deuxième zone isolée de manière étanche de la première zone.

Outre les caractéristiques qui viennent d'être évoquées dans les paragraphes précédents, le système électromécanique selon l'invention peut présenter une ou plusieurs caractéristiques complémentaires parmi les suivantes, considérées individuellement ou selon toutes les combinaisons techniquement possibles :

- l'élément mobile est en translation par rapport au bâti ;

- l'élément mobile est en rotation par rapport au bâti ;

- au moins une des premières articulations pivot est située au niveau de la première électrode mobile et une autre des premières articulations pivot est située à une extrémité du premier arbre de transmission, opposée à la première électrode mobile ;

- au moins une des deuxièmes articulations pivot est située au niveau de la deuxième électrode mobile et une autre des deuxièmes articulations pivot est située à une extrémité du deuxième arbre de transmission, opposée à la deuxième électrode mobile ;

- les premiers bras de transmission s'étendent perpendiculairement au premier axe longitudinal de rotation ;

- les deuxièmes bras de transmission s'étendent perpendiculairement au deuxième axe longitudinal de rotation ;

- le premier axe longitudinal de rotation est parallèle au deuxième axe longitudinal de rotation ;

- la première électrode mobile et la deuxième électrode mobile sont symétriques par rapport à un plan séparant les première et deuxième moitiés de l'élément mobile ;

- le premier dispositif de transmission et le deuxième dispositif de transmission sont symétriques par rapport à un plan séparant les première et deuxième moitiés de l'élément mobile ;

- la première extrémité de chaque premier bras de transmission est située à une distance $L_{pist1}$ du premier axe longitudinal de rotation telle que : $\frac{1}{2} \times L_{elec1} \leq L_{pist1} \leq 2 \times L_{elec1}$, où $L_{elec1}$ est la distance entre un bord longitudinal de la première électrode mobile et le premier axe longitudinal de rotation ;

- la première extrémité de chaque deuxième bras de transmission est située à une distance $L_{pist2}$ du deuxième axe longitudinal de rotation telle que : $\frac{1}{2} \times L_{elec2} \leq L_{pist2} \leq 2 \times L_{elec2}$, où $L_{elec2}$ est la distance entre un bord longitudinal de la deuxième électrode mobile et le deuxième axe longitudinal de rotation ;

- au moins une partie du premier arbre de transmission située en regard de l'élément mobile est ajourée ;

- au moins une partie du deuxième arbre de transmission située en regard de l'élément mobile est ajourée ;

- le premier arbre de transmission et les premiers bras de transmission s'étendent dans la première zone et le premier dispositif de transmission comprend en outre des piliers s'étendant en partie dans la première zone et en partie dans la deuxième zone ;

- le deuxième arbre de transmission et les deuxièmes bras de transmission s'étendent dans la première zone et le deuxième dispositif de transmission comprend en outre des piliers s'étendant en partie dans la première zone et en partie dans la deuxième zone ;

- le premier arbre de transmission et les premiers bras de transmission présentent une épaisseur comprise entre 5 $\mu$m et 800 $\mu$m, de préférence entre 50 $\mu$m et 200 $\mu$m ;

- le deuxième arbre de transmission et les deuxièmes bras de transmission présentent une épaisseur comprise entre 5 $\mu$m et 800 $\mu$m, de préférence entre 50 $\mu$m et 200 $\mu$m ;

- la première électrode mobile comprend une membrane et une structure de rigidification de la membrane ;

- la structure de rigidification de la première électrode mobile est ancrée au premier dispositif de transmission au niveau d'une partie des premières articulations pivot ;

- la structure de rigidification de la première électrode mobile comprend une pluralité de poutres s'étendant parallèlement les unes aux autres et une partie au moins des poutres sont ancrées au premier dispositif de transmission, chaque poutre de ladite au moins une partie étant ancrée au niveau d'une première articulation pivot correspondant à ladite poutre ;

- chaque première articulation pivot de ladite au moins une partie comprend un élément d'isolation étanche apte à se déformer élastiquement et assurant l'étanchéité entre la première zone et la deuxième zone ;

- la deuxième électrode mobile comprend une membrane et une structure de rigidification de la membrane ;

- la structure de rigidification de la deuxième électrode mobile est ancrée au deuxième dispositif de transmission au niveau d'une partie des deuxièmes articulations pivot ;

- la structure de rigidification de la deuxième électrode mobile comprend une pluralité de poutres s'étendant parallèlement les unes aux autres et une partie au moins des poutres sont ancrées au deuxième dispositif de transmission, chaque poutre de ladite au moins une partie étant ancrée au niveau d'une deuxième articulation pivot correspondant à ladite poutre ;

- chaque deuxième articulation pivot de ladite au moins une partie comprend un élément d'isolation étanche apte à se déformer élastiquement et assurant l'étanchéité entre la première zone et la deuxième zone ;

- les moyens capacitifs de mesure ou d'actionnement comprennent des première et deuxième électrodes fixes associées à la première électrode mobile, la première électrode mobile comprenant une membrane disposée entre les première et deuxième électrodes fixes ;

- chacune des première et deuxième électrodes fixes comprend une première portion et une deuxième portion situées de part et d'autre de la membrane et de part et d'autre des premières articulations pivot, les première et deuxième portions étant reliées électriquement ;

- les moyens capacitifs de mesure ou d'actionnement comprennent en outre des troisième et quatrième électrodes fixes associées à la deuxième électrode mobile, la deuxième électrode mobile comprenant une membrane disposée entre les troisième et quatrième électrodes fixes ; et

- chacune des troisième et quatrième électrodes fixes comprend une première portion et une deuxième portion situées de part et d'autre de la membrane et de part et d'autre des deuxièmes articulations pivot, les première et deuxième portions étant reliées électriquement.

## BREVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :

- la figure 1 est une vue en perspective partielle d'un microphone à détection capacitive selon l'art antérieur ;

- la figure 2 est une vue de dessous partielle d'un système électromécanique selon un premier mode de réalisation de l'invention, ce système électromécanique comprenant des moyens capacitifs de détection ou d'actionnement ;

- la figure 3 est une vue de dessus partielle des moyens capacitifs de détection ou d'actionnement du système électromécanique de la figure 2 ;

- la figure 4A est une vue en coupe du système électromécanique selon le plan de coupe A-A de la figure 3 ;

- la figure 4B est une vue en coupe du système électromécanique selon le plan de coupe B-B de la figure 3 ;

- la figure 4C est une vue en coupe du système électromécanique selon le plan de coupe C-C de la figure 3 ;

- la figure 5 est une vue de dessous partielle d'un système électromécanique selon un deuxième mode de réalisation de l'invention ;

- la figure 6 est une vue de dessus des moyens capacitifs de détection ou d'actionnement du système électromécanique de la figure 5 ;

- la figure 7 est une vue de dessous partielle d'un système électromécanique selon un troisième mode de réalisation de l'invention ;

- la figure 8 est une vue de dessous partielle d'un système électromécanique selon un quatrième mode de réalisation de l'invention ;

- la figure 9 est une vue de dessous partielle d'un système électromécanique selon un cinquième mode de réalisation de l'invention ; et

- la figure 10 est une vue de dessous partielle d'un système électromécanique selon un sixième mode de réalisation de l'invention.

Pour plus de clarté, les éléments identiques ou similaires sont repérés par des signes de référence identiques sur l'ensemble des figures.

## DESCRIPTION DETAILLEE

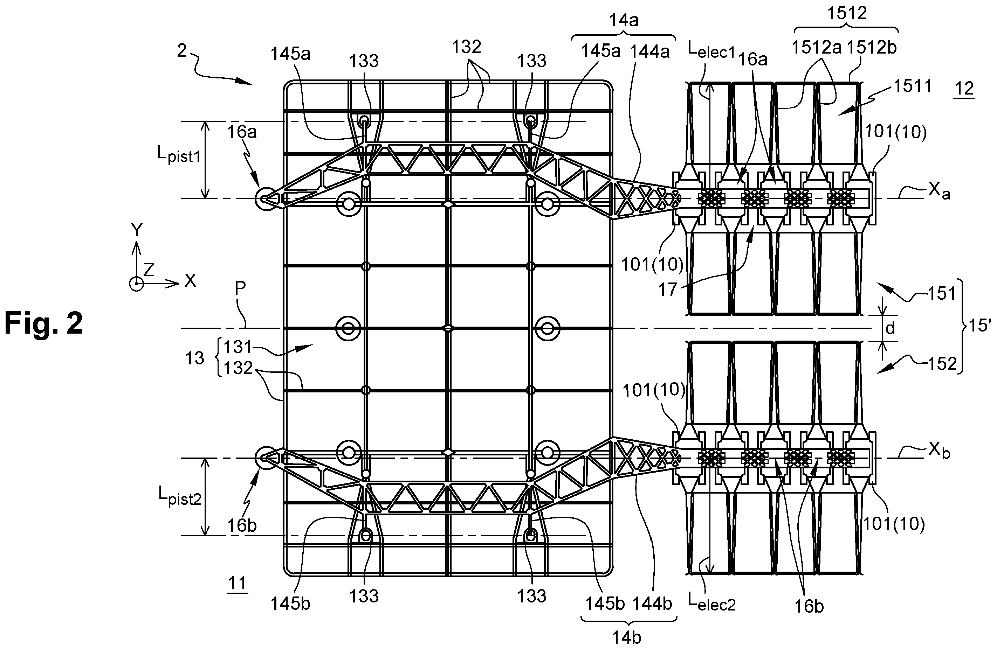

Les figures 2, 3 et 4A à 4C représentent une partie d'un système électromécanique 2 à détection capacitive ou actionnement capacitif selon un premier mode de réalisation de l'invention. Ce système électromécanique 2 peut former un transducteur électroacoustique, par exemple un microphone ou un haut-parleur, ou un capteur de pression différentielle. Dans la description qui suit, on prendra l'exemple d'un microphone à détection capacitive.

Le système électromécanique 2 comprend :

- un bâti 10 ;

- un élément mobile 13 en contact avec une première zone 11 ;

- des moyens de détection (ou mesure) capacitive 15' comprenant une première électrode 151 mobile par rapport au bâti 10, une deuxième électrode 152 mobile par rapport au bâti 10, les première et deuxième électrodes mobiles 151-152 étant situées dans une deuxième zone 12 isolée de manière étanche de la première zone 11 ; et

- un premier dispositif de transmission 14a d'un mouvement entre l'élément mobile 13 et la première électrode mobile 151 (autrement dit entre la première zone 11 et la deuxième zone 12) ; et

- un deuxième dispositif de transmission 14b d'un mouvement entre l'élément mobile 13 et la deuxième électrode mobile 152.

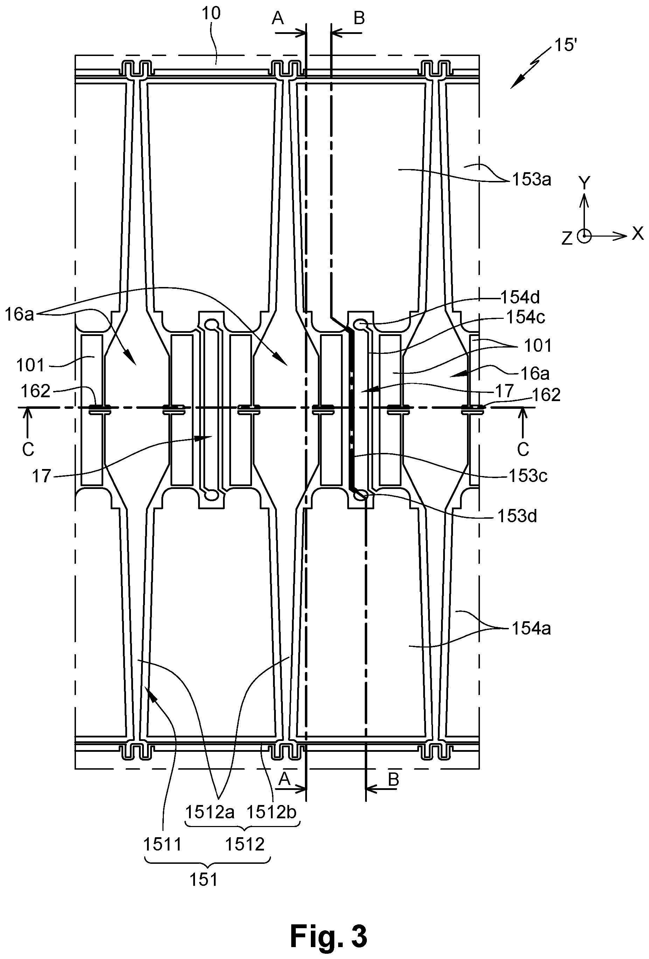

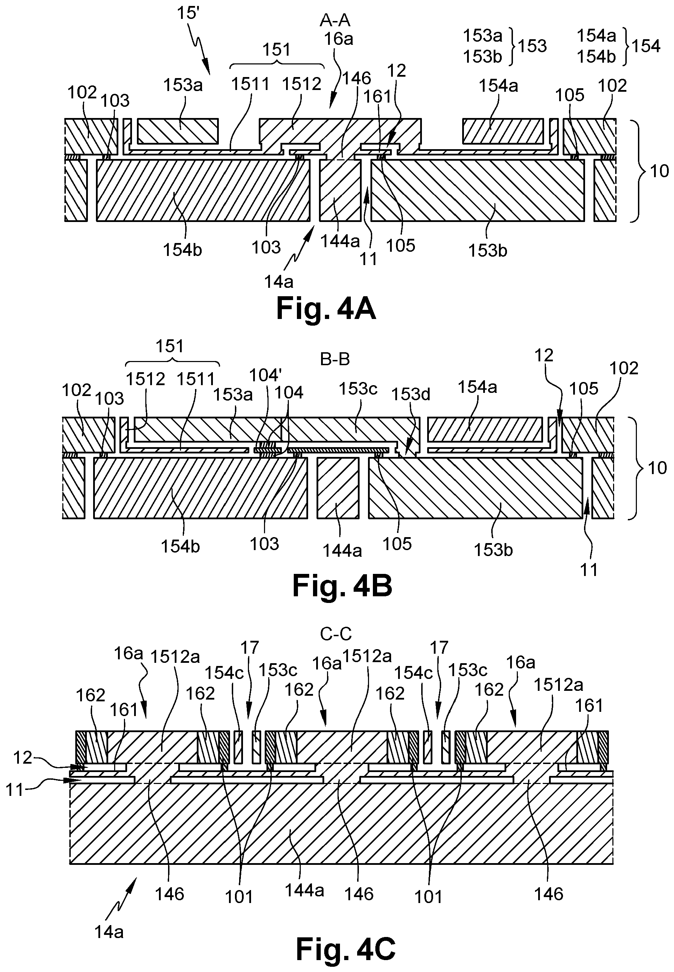

La figure 2 est une vue de dessous du système électromécanique 2 montrant des premières portions 101 du bâti 10, l'élément mobile 13, les dispositifs de transmission 14a-14b et les électrodes mobiles 151-152 des moyens de détection capacitive 15'. La figure 3 est une vue de dessus montrant seulement une partie des moyens de détection capacitive 15' (dont la première électrode mobile 151). Les figures 4A à 4C sont différentes vues de coupe du système électromécanique 2, respectivement selon les plans de coupe A-A, B-B et C-C représentés sur la figure 3. Elles représentent en partie le bâti 10, le premier dispositif de transmission 14a et les moyens de détection capacitive 15'.

L'élément mobile 13, appelé ci-après piston, est ici mobile en translation par rapport au bâti 10, selon une direction (Z) perpendiculairement au plan (XY) de la figure 2. Il comprend de préférence une membrane 131 et une structure de rigidification 132 de la membrane 131, aussi appelée squelette ou armature. La membrane 131 du piston 13 a ici pour rôle de récolter sur toute sa surface une différence de pression entre ses deux faces, pour en déduire une variation de la pression atmosphérique.

La membrane 131 du piston 13 peut délimiter en partie un volume fermé dit de référence, où règne une pression de référence. Elle sépare ce volume de référence d'une cavité ouverte sur l'environnement extérieur, ici l'air. Une face de la membrane 131 est donc soumise à la pression de référence et une face opposée de la membrane 131 est soumise à la pression atmosphérique (dont on souhaite détecter la variation dans le cas d'un microphone). Alternativement, le volume de référence peut être quasi-fermé, au sens où il existe une tranchée autour du piston (qui est détouré). Cette tranchée permet au piston de bouger et autorise une fuite d'air entre le volume de référence et l'extérieur. Cette fuite est faible pour que les pressions puissent s'égaliser lentement, de sorte à filtrer uniquement les variations de pression de basses fréquences (< 100 Hz).

La première zone 11 englobe la cavité ouverte sur l'environnement extérieur, soumise à la pression atmosphérique, et volume de référence soumis à la pression de référence.

Les moyens de détection capacitive 15' permettent de mesurer le déplacement du piston 13, et donc la différence de pression entre ses deux faces. Outre les première et deuxième électrodes mobiles 151-152, ils comprennent au moins une électrode fixe (par rapport au bâti 10), séparée de la première électrode mobile 151 par un premier milieu diélectrique, et au moins une électrode fixe additionnelle, séparée de la deuxième électrode mobile 152 par un deuxième milieu diélectrique.

Chaque électrode mobile et électrodes fixe(s) associées forment les armatures d'un ou plusieurs condensateurs dont la capacité varie en fonction du déplacement du piston 13. Les électrodes fixes peuvent être également appelées « contre-électrodes ».

Le premier milieu diélectrique et le deuxième milieu diélectrique ne sont pas solides (mais de préférence constitués par un gaz ou un mélange de gaz), pour ne pas entraver le mouvement des électrodes mobiles 151. Le deuxième milieu diélectrique est ici identique au premier milieu diélectrique, car les électrodes mobiles 151-152 sont toutes les deux situées dans la deuxième zone 12.

La deuxième zone 12 est avantageusement une chambre sous atmosphère contrôlée pour réduire les phénomènes de frottement visqueux et les bruits acoustiques associés. Par « chambre sous atmosphère contrôlée », on entend une chambre sous une pression réduite, typiquement inférieure à 10 mbar, et de préférence inférieure à 1 mbar. Ainsi, la deuxième zone 12 est ici soumise à une pression bien inférieure à la pression atmosphérique ou la pression de référence.

Le premier dispositif de transmission 14a est monté mobile en rotation par rapport au bâti 10, au moyen de plusieurs premières articulations pivot 16a. Il comprend un premier arbre de de transmission 144a et des premiers bras de transmission 145a.

Le premier arbre de transmission 144a présente un premier axe longitudinal de rotation Xa (désigné ci-après premier arbre Xa), qui s'étend dans une première direction X. Autrement dit, le premier arbre de transmission 144a peut pivoter sur lui-même, autour du premier axe Xa. Il s'étend en regard du piston 13, en regard d'une zone située entre le piston 13 et la première électrode mobile 151 et en regard de la première électrode mobile 151.

La première électrode mobile 151 est solidaire du premier arbre de transmission 144a, ce qui signifie qu'il n'y a pas de mouvement relatif entre la première électrode mobile 151 et le premier arbre de transmission 144a. La première électrode mobile 151 est donc également montée mobile en rotation autour du premier axe Xa.

Le système électromécanique 2 est ainsi dépourvu d'organes de transformation du mouvement entre le premier dispositif de transmission 14a et la première électrode mobile 151, tels que des lames de torsion pour passer d'une rotation à une translation. Il en résulte qu'aucune énergie n'est perdue dans ces organes de transformation (par exemple, par déformation des lames de torsion).

Les premiers bras de transmission 145a, par exemple au nombre de deux sur la figure 2, s'étendent de préférence perpendiculairement au premier axe Xa, autrement dit dans une deuxième direction Y perpendiculaire à la première direction X. Les première et deuxième directions X-Y constituent avec une troisième direction Z perpendiculaire un repère orthogonal.

Chaque premier bras de transmission 145a comprend une première extrémité couplée au piston 13 et une deuxième extrémité solidaire du premier arbre de transmission 144a. Un ou plusieurs éléments de couplage 133 (par exemple des lames de torsion) relient la structure de rigidification 132 du piston 13 à la première extrémité de chaque premier bras de transmission 145a et permettent le passage d'un mouvement de translation (piston 13) à un mouvement de rotation (premier arbre de transmission 144a et première électrode mobile 151) tout en couplant fortement leur déplacement selon la troisième direction Z. Ces éléments de couplage 133 sont aptes à se déformer élastiquement.

Le mouvement de translation du piston 13 entraine la rotation des premiers bras de transmission 145a, et donc du premier arbre de transmission 144a, autour du premier axe Xa. Puis, ce mouvement de rotation est transmis à la première électrode mobile 151.

Les premières articulations pivot 16a, par exemple au nombre de six, sont alignées, ici dans la première direction X. De préférence, l'une des premières articulations pivot 16a est située à l'extrémité du premier arbre de transmission 144a, du côté du piston 13 (soit à l'opposé de la première électrode mobile 151), tandis que d'autres premières articulations pivot 16a sont situées du côté de la première électrode mobile 151. Comme il sera décrit en détail par la suite, la première électrode mobile 151 est de préférence reliée au premier arbre de transmission 144a au niveau de ces autres premières articulations pivot 16a.

Le deuxième dispositif de transmission 14b est également monté mobile en rotation par rapport au bâti 10, au moyen de deuxièmes articulations pivot 16b. Il est construit de la même façon que le premier dispositif de transmission 14a. Plus particulièrement, il comprend un deuxième arbre de transmission 144b présentant un deuxième axe longitudinal de rotation Xb (désigné ci-après deuxième axe Xb) et des deuxièmes bras de transmission 145b (par exemple deux). Chaque deuxième bras de transmission 145b comprend une première extrémité couplée (par l'intermédiaire d'un ou plusieurs éléments de couplage 133) au piston 13 et une deuxième extrémité solidaire du deuxième arbre de transmission 144b. Les deuxièmes bras de transmission 145b s'étendent de préférence perpendiculairement au deuxième axe Xb.

La deuxième électrode mobile 152 est solidaire du deuxième arbre de transmission 144b et tourne donc autour du deuxième axe Xb.

Les deuxièmes articulations pivot 16b sont de préférence réparties sur le deuxième axe Xb de la même façon que les premières articulations pivot 16a sont réparties sur le premier axe Xa (l'une d'elles est située à l'extrémité du deuxième arbre de transmission 144b et d'autres sont situées au niveau de la deuxième électrode mobile 152).

Les premiers bras de transmission 145a sont couplés à une première moitié du piston 13 (la moitié supérieure sur la figure 2) et les deuxièmes bras de transmission 145b sont couplés à une deuxième moitié du piston 13 (la moitié inférieure sur la figure 2). Ainsi, les dispositifs de transmission 14a-14b supportent le piston 13 et le maintiennent dans un mouvement de translation. De préférence, le piston 13 est tenu uniquement par les premiers et deuxièmes bras de transmission 145a-145b. Ainsi, une plus grande proportion de l'énergie collectée par le piston 13 est transmise aux électrodes mobiles 151-152.

Comme cela est illustré par la figure 2, le premier axe Xa et le deuxième axe Xb sont avantageusement parallèles. Cela contribue à réduire l'encombrement du système électromécanique 2 et permet de soutenir le piston de manière homogène.

La première électrode mobile 151 et la deuxième électrode mobile 152 peuvent être identiques et disposées de manière symétrique par rapport à un plan P séparant les première et deuxième moitiés du piston 13. Cette symétrie permet d'obtenir une réaction identique sur les deux moitiés du piston pour que celui-ci se maintienne bien en translation.

Le premier dispositif de transmission 14a et le deuxième dispositif de transmission 14b peuvent être également symétriques par rapport au plan P. Le premier arbre de transmission 144a et la première électrode mobile 151 pivotent alors dans un sens (autour du premier axe Xa), alors que le deuxième arbre de transmission 144b et la deuxième électrode mobile 152 pivotent dans le sens inverse (autour du deuxième axe Xb).

Le piston 13 peut également présenter une symétrie par rapport au plan P.

Les symétries du piston 13 et des dispositifs de transmission 14a-14b permettent de répartir l'énergie collectée par le piston 13 équitablement entre la première électrode mobile 151 et la deuxième électrode mobile 152. En effet, la masse du piston 13 est répartie équitablement entre les première et deuxième moitiés, et donc entre les premier et deuxième dispositifs de transmission 14a-14b.

Le montage en rotation de la première électrode mobile 151 et de la deuxième électrode mobile 152, selon respectivement le même axe de rotation que le premier dispositif de transmission 14a et le deuxième dispositif de transmission 14b, permet d'obtenir un plus grand déplacement des électrodes mobiles 151-152 pour un déplacement du piston 13 donné, sans toutefois augmenter l'encombrement du système électromécanique 2. En effet, la longueur des arbres de transmission 144a-144b n'influe pas sur l'amplitude du déplacement des électrodes mobiles 151-152. Les électrodes mobiles 151-152 peuvent donc être rapprochées autant que possible du piston 13.

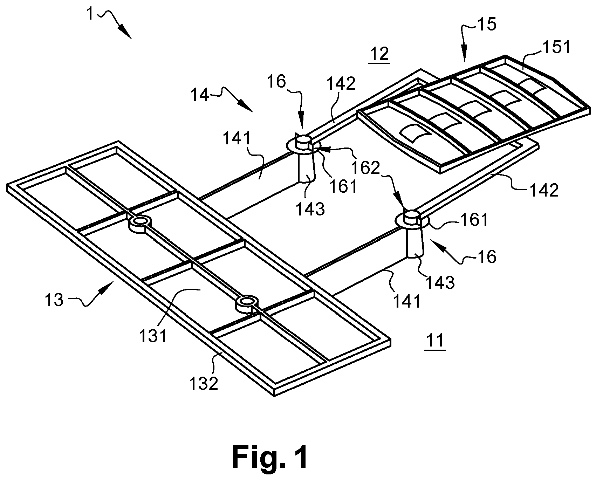

Le passage d'une électrode mobile (Fig.1) à deux électrodes mobiles (Fig.2) n'augmente pas non plus l'encombrement du système électromécanique 2 de manière significative, car les deux électrodes mobiles 151-152 peuvent être disposées en vis-à-vis dans le prolongement du piston 13. La distance d qui sépare les électrodes mobiles 151-152 est par exemple comprise entre 10 μm et 100 μm.

Le déplacement de chaque électrode mobile 151, 152 rapporté à celui du piston 13 est fonction de la distance $L_{pist1}$, $L_{pist2}$ entre la première extrémité des arbres de transmission 145a, 145b et l'axe de rotation Xa, Xb correspondant. Cette distance peut être du même ordre de grandeur que la distance $L_{elec1}$, $L_{elec2}$ entre un bord longitudinal (c'est-à-dire selon X) de l'électrode mobile 151, 152 et l'axe de rotation Xa, Xb.

Plus précisément, le déplacement en Z du bord longitudinal de la première électrode mobile 151 est donné par la relation suivante :

[Math. 1]

$$d_{Zelec1} = \frac{L_{elec1}}{L_{pist1}} \times d_{Zpist}$$

où $d_{Zpist}$ est le déplacement en Z du piston 13 (et donc de toutes les premières extrémités des premiers et deuxièmes bras de transmission 145a-145b), $L_{elec1}$ est la distance entre le bord longitudinal de la première électrode mobile 151 et le premier axe Xa et $L_{pist1}$ est la distance entre la première extrémité de chaque premier bras de transmission 145a et le premier axe Xa.

Le déplacement en Z du bord longitudinal de la deuxième électrode mobile 152 est donné par la relation suivante :

[Math. 2]

$$d_{Zelec2} = \frac{L_{elec2}}{L_{pist2}} \times d_{Zpist}$$

où $L_{elec2}$ est la distance entre le bord longitudinal de la deuxième électrode mobile 152 et le deuxième axe Xb et $L_{pist2}$ est la distance entre la première extrémité de chaque deuxième bras de transmission 14b et le deuxième axe Xb.

De préférence, la distance $L_{pist1}$ entre la première extrémité de chaque premier bras de transmission 145a et le premier axe Xa est telle que :

[Math. 3]

$$\frac{1}{2} \times L_{elec1} \leq l_{pist1} \leq 2 \times l_{elec1}$$

et la distance $L_{pist2}$ entre la première extrémité de chaque deuxième bras de transmission 14b et le deuxième axe Xb est telle que :

[Math. 4]

$$\frac{1}{2} \times L_{elec2} \leq L_{pist2} \leq 2 \times L_{elec2}$$

Les arbres de transmission 144a-144b et les bras de transmission 145a-145b peuvent être particulièrement rigides, et donc peu sensibles aux déformations qui équivalent à des pertes d'énergie. Cette rigidité des arbres de transmission 144a-144b et des bras de transmission 145a-145b peut notamment être conférée par une épaisseur importante (mesurée dans la troisième direction Z), de préférence comprise entre 5 $\mu$m et 800 $\mu$m, et plus préférentiellement entre 50 $\mu$m et 200 $\mu$m. Les arbres de transmission 144a-144b et les bras de transmission 145a-145b sont avantageusement formés par gravure d'un substrat en silicium. Ce substrat peut être aminci, jusqu'à une épaisseur comprise entre 50 $\mu$m et 200 $\mu$m. Alternativement, les premiers éléments du dispositif de transmission 14' sont formés par une couche épitaxiée d'épaisseur comprise entre 5 $\mu$m et 40 $\mu$m.

Comme les arbres de transmission 144a-144b tournent sur eux-mêmes, leur inertie reste faible et n'impacte pas négativement la fréquence de résonance du système électromécanique 2. Toutefois, ils peuvent être ajourés, comme cela est illustré sur la figure 2, afin d'optimiser leur ratio rigidité sur inertie. Les arbres de transmission 144a-144b sont de préférence ajourés au moins dans la portion située en regard du piston 13. Cela permet en outre de limiter l'amortissement avec le piston 13 (phénomène appelé « squeeze film damping » en anglais), qui est une source de bruit.

La largeur des bras de transmission 145a-145b (mesurée dans la première direction X) est du même ordre de grandeur que leur épaisseur, afin de minimiser leur inertie. Elle est avantageusement comprise entre 5 $\mu$m et 800 $\mu$m, de préférence entre 50 $\mu$m et 200 $\mu$m.

Comme illustré sur la figure 2, les arbres de transmission 144a-144b peuvent comprendre chacun une portion décentrée par rapport à leur axe de rotation Xa, Xb (et qui s'étend parallèlement à cet axe), afin d'aménager de la place pour la structure de rigidification 132 du piston 13. Une partie de la structure de rigidification 132 peut en effet être située du même côté de la membrane 131 que les arbres de transmission 144a-144b (et formée dans le même substrat en silicium). La partie restante de la structure de rigidification 132 est située du côté opposé de la membrane 131.

Les moyens de détection capacitive 15' vont maintenant être décrits plus en détail, en se référant uniquement à la première électrode mobile 151 (connectée au premier dispositif de transmission 14a). Néanmoins, cette description s'applique *mutatis mutandis* à la deuxième électrode mobile 152 (connectée au deuxième dispositif de transmission 14b), étant donné qu'elle peut être identique à la première électrode 151. De même, la description qui sera faite des premières articulations pivot 16a vaut pour les deuxièmes articulations pivot 16b.

En référence aux figures 2 et 3, la première électrode 151 peut comprendre une membrane 1511 et une structure de rigidification 1512 de la membrane 1511. La structure de rigidification 1512 comprend de préférence une pluralité de premières poutres 1512a s'étendant parallèlement les unes aux autres. Elle peut en outre comprendre des deuxièmes poutres 1512b reliant les premières poutres 1512a à leurs extrémités.

Les premières poutres 1512a s'étendent de préférence dans la deuxième direction Y, avantageusement d'un premier bord à un deuxième bord opposé de la première électrode mobile 151. Elles sont avantageusement espacées régulièrement les unes des autres, pour rigidifier la membrane 1511 de manière uniforme. Les deuxièmes poutres 1512b s'étendent de préférence dans la première direction X (donc perpendiculairement aux premières poutres 1512a).

La première électrode mobile 151 présente avantageusement un ou plusieurs plans de symétrie, par exemple un plan parallèle au plan XZ (donc perpendiculaire aux premières poutres 1512a) et un autre plan parallèle au plan YZ.

La structure de rigidification 1512 de la première électrode mobile 151 est avantageusement ancrée, ou fusionnée, au premier dispositif de transmission 14a au niveau d'une partie des premières articulations pivot 16a. Par rapport au microphone 1 de la figure 1, le système électrostatique 2 est donc dépourvu des deuxièmes bras de transmission 142 s'étendant dans la deuxième zone 12.

Plus particulièrement, la structure de rigidification 1512 de la première électrode mobile 151 est reliée au premier dispositif de transmission 14a, et plus particulièrement au premier arbre de transmission 144a, par des piliers 146 visibles sur les figures 4A et 4C. Les piliers 146 du premier dispositif de transmission 14a sont semblables aux arbres de transmission 143 de la figure 1, car ils s'étendent en partie dans la première zone 11 et en partie dans la deuxième zone 12. En effet, l'étanchéité entre la première zone 11 et la deuxième zone 12 s'effectue également au niveau des premières articulations pivot 16a associées à la première électrode mobile 151.

Le premier dispositif de transmission 14a est ainsi réduit à des premiers éléments s'étendant exclusivement dans la première zone 11 (le premier arbre de transmission 144a et les premiers bras de transmission 145a) et à des deuxièmes éléments (les piliers 146) qui s'étendent en partie dans la première zone 11 et en partie dans la deuxième zone 12. Cette réduction du premier dispositif de transmission 14a permet de limiter les pertes d'énergie. Il n'y a notamment plus de pertes par déformation des deuxièmes bras de transmission 142.

Le système électromécanique 2 est particulièrement compact, car plusieurs fonctions, à savoir la mise en rotation du premier dispositif de transmission 14a, l'étanchéité entre les deux zones 11-12 et la connexion à la première électrode mobile 151, sont réalisées au même endroit.

L'ancrage entre la structure de rigidification 1512 et le premier dispositif de transmission 14a est de préférence réalisé au moyen des premières poutres 1512a. Une partie au moins d'entre elles sont fusionnées au premier dispositif de transmission 14a, chacune au niveau d'une première articulation pivot 16a correspondante. Le point d'ancrage de chaque première poutre 1512a se situe avantageusement à la moitié de sa longueur. Ainsi, l'axe de rotation de la première électrode mobile 151 se situe dans un des plans de symétrie de la première électrode mobile 151 (celui perpendiculaire aux première poutres 1512a). La longueur des premières poutres 1512a est mesurée dans la deuxième direction Y, tandis que leur largeur est mesurée dans la première direction X.

Chaque première poutre 1512a fusionnée avec le premier dispositif de transmission 14a présente avantageusement une largeur qui décroit en s'éloignant de la première articulation pivot 16a correspondante. Autrement dit, la largeur des premières poutres 1512a est maximale au niveau des premières articulations pivot 16a. Ainsi, la structure de rigidification 1512 est la plus rigide aux endroits où elle est la plus sollicitée mécaniquement, c'est-à-dire près de l'axe de rotation. Cela contribue à réduire les pertes d'énergie par déformation, en limitant l'impact négatif sur l'inertie de la première électrode mobile 151 et donc la fréquence de résonance du système électromécanique 2.

Dans ce premier mode de réalisation du système électromécanique 2, chacune des premières poutres 1512a de la structure de rigidification 1512 est fusionnée au premier dispositif de transmission 14a. En d'autres termes, à chaque première poutre 1512a est associée une première articulation pivot 16a. Le nombre de premières articulations pivot 16a du côté de la première électrode mobile 151 est donc égal au nombre de première poutres 1512a. Cette disposition permet d'aménager un espace 17 entre deux premières articulations pivot 16a successives.

Le bâti 10 peut comprendre, pour chaque première articulation pivot 16a, deux premières portions 101 distinctes disposées de part et d'autre de la première poutre 1512a associée à la première articulation pivot. La première poutre 1512a est de préférence reliée à chacune des premières portions 101 du bâti 10 par une lame de torsion 162 (cf. Fig.3).

Comme cela est représenté par les figures 3, 4A à 4C, les moyens de détection capacitive 15' comprennent de préférence deux contre-électrodes 153-154 associées à la première électrode mobile 151 : une première contre-électrode 153 dite positive et une deuxième contre-électrode 154 dite négative. Préférentiellement, une partie au moins de la membrane 1511 de la première électrode mobile 151 est située entre les deux contre-électrodes 153-154 (cf. Figs.4A-4C). La première électrode mobile 151 et les contre-électrodes 153-154 forment ainsi les armatures de deux condensateurs dont les capacités varient dans des sens opposés. Une mesure différentielle du déplacement du piston 13 peut être ainsi obtenue. Les surfaces des contre-électrodes 153-154 en regard de la première électrode mobile 151 sont avantageusement identiques, grâce à une symétrie de la première électrode mobile 151 et des contre-électrodes 153-154 par rapport aux premières articulations pivot 16a (le plan de symétrie est confondu avec le plan de coupe C-C).

Avantageusement, chacune des contre-électrodes 153, 154 comprend une première portion 153a, 154a et une deuxième portion 153b, 154b situées de part et d'autre de la membrane 1511 et de part et d'autre des premières articulations pivot 16a. La première portion 153a, 154a, dite supérieure, et la deuxième portion 153b, 154b, dite inférieure, d'une même contre-électrode sont reliées électriquement. Cette disposition permet d'obtenir une mesure totalement différentielle, même si la distance entre la membrane 1511 et les portions supérieures 153a-154a des contre-électrodes (appelée entrefer supérieur) est différente de la distance entre la membrane 1511 et les portions inférieures 153a-154a des contre-électrodes (entrefer inférieur).

Les portions inférieures 153b-154b des contre-électrodes 153-154 s'étendent sous les première poutres 1512a de la structure de rigidification 1512, de chaque côté des premières articulations pivot 16a. En revanche, les portions supérieures 153a-154a des contre-électrodes 153-154 sont de préférence divisées chacune en plusieurs blocs (ou sous-portions) séparées par les premières poutres 1512a, comme cela est illustré par la figure 3. Les portions supérieures 153a-154a des contre-électrodes 153-154 étant inscrites dans la structure de rigidification 1512, leur surface en regard de la membrane 1511 est inférieure à celle des portions inférieures 153b-154b.

Chaque bloc de la portion supérieure 153a de la première contre-électrode 153 peut être relié électriquement à la portion inférieure 153b de cette même contre-électrode par un premier connecteur 153c et un premier via conducteur 153d. De même, chaque bloc de la portion supérieure 154a de la deuxième contre-électrode 154 peut être relié électriquement à la portion inférieure 154b de cette même contre-électrode par un deuxième connecteur 154c et un deuxième via conducteur 154d.

Les premier et deuxième connecteurs 153c-154c s'étendent avantageusement dans l'espace 17 situé entre deux premières articulations pivot 16a. Ainsi, la connexion électrique des portions supérieure et inférieur d'une même contre-électrode est simplifiée et n'augmente pas l'encombrement des moyens de détection capacitive 15'.

Alternativement, les différents blocs d'une portion supérieure de contre-électrode peuvent être reliés directement entre eux, par exemple à la périphérie de la première électrode mobile 151.

En référence aux figures 4A et 4B, les portions inférieures 153b-154b des contre-électrodes 153-154 sont de préférence solidarisées à une portion annulaire 102 du bâti 10, située à la périphérie de la première électrode mobile 151, au moyen de joints annulaires 103, 105 en un matériau électriquement isolant (un joint annulaire par portion inférieure 153b, 154b). Ces joints annulaires 103, 105, par exemple en oxyde de silicium, assurent en outre l'étanchéité entre la première zone 11 et la deuxième zone 12.

En outre, chacun des blocs des portions supérieures 153a, 154a des contre-électrodes 153-154 peut être solidarisé à la portion inférieure 154b, 153b sous-jacente, grâce à (au moins) deux piliers 104 électriquement isolant, de préférence formés du même matériau que celui des joints annulaires 103, 105. Les piliers 104 peuvent être séparés deux à deux par une couche résiduelle 104' formée du même matériau que celui de la membrane 1511 de la première électrode mobile 151, par exemple du silicium. L'épaisseur des piliers 104 est alors égal à l'entrefer supérieur et à l'entrefer inférieur. Dans le cas contraire, il n'y a qu'un seul pilier « double », dont l'épaisseur est égale à la somme de l'entrefer supérieur, l'entrefer inférieur et l'épaisseur de la membrane 1511. Le(s) pilier(s) 104 et la couche résiduelle 104' permettent de réduire les capacités parasites entre les portions supérieures 153a, 154a et les portions inférieures 153b-154b des contre-électrodes.

De façon alternative, les moyens de détection capacitive 15' peuvent comprendre (pour chaque électrode mobile) qu'une seule contre-électrode (inférieure ou supérieure), deux contre-électrodes supérieure et inférieure mais situées d'un seul côté des articulations pivot 16 (détection pseudo-différentielle) ou encore deux contre-électrodes inférieures ou supérieures disposées de part et d'autre des articulations pivot 16 (détection différentielle).

Comme indiqué précédemment, l'étanchéité entre les première et deuxième zones 11-12 du système électromécanique 2 peut être réalisée au niveau des premières articulations pivot 16a situées du côté de la première électrode mobile 151. Comme illustré sur les figures 4A et 4C, chaque première articulation pivot 16a associée à la première électrode mobile 151 comprend un élément d'isolation étanche 161, apte à se déformer élastiquement sous l'effet du déplacement en rotation du premier dispositif de transmission 14a. L'élément d'isolation étanche 161 se présente de préférence sous la forme d'une membrane d'étanchéité.

Chaque élément d'isolation étanche 161 est de préférence traversé par un pilier 146 associé du premier dispositif de transmission 14a. L'élément d'isolation étanche 161 s'étend par exemple depuis le pilier 146 associé jusqu'aux portions inférieures 153b-154b des contre-électrodes 153-154 (cf. Fig.4A) et aux premières portions 101 du bâti 10 (cf. Fig.4C), auxquelles il est ancré grâce aux joints annulaires 103, 105 en matériau électriquement isolant.

En outre, chaque première articulation pivot 16a (associée à la première électrode mobile 151) comprend avantageusement deux lames de torsion 162 (une par première portion 101 du bâti 10). Les lames de torsion 162 sont dimensionnées de sorte à pouvoir se déformer en torsion et permettre la rotation du premier dispositif de transmission 14a et de la première électrode mobile 151, tout en limitant leurs mouvements de translation, notamment selon la troisième direction Z (translation dite « hors plan »). Les deux lames de torsion 162 relient la structure de rigidification 1512 de la première électrode mobile 151 (fusionnée au pilier 146 du premier dispositif de transmission 14a) aux premières portions 101 du bâti 10 (cf. également Fig.4C). Elles sont de préférence alignées et disposées de façon diamétralement opposée par rapport à la première poutre 1512a associée à la première articulation pivot 16a.

La première articulation pivot 16a située à l'extrémité du premier arbre de transmission 144a comprend avantageusement un élément d'isolation étanche 161 (de préférence sous la forme d'une membrane) et deux lames de torsion 162, mais ne participe pas à l'étanchéité entre les première et deuxième zones 11-12 (étant située uniquement dans la première zone 11).

Le système électromécanique 2 comprend des moyens élastiques reliés à la première électrode mobile 151et configurés pour générer une force élastique qui s'oppose au mouvement de la première électrode mobile 151. Le rôle de ces moyens élastiques est de lutter contre le phénomène d'effondrement (appelé « pull-in » en anglais) de la première électrode mobile 151. Leur raideur influe sur la tension d'effondrement (ou « pull-in voltage » du système), donc sur la faculté à polariser la première électrode mobile 151, mais également sur les pertes d'énergie.

Les moyens élastiques « anti-pull-in » relient (mécaniquement) la structure de rigidification 1512 de la première électrode mobile 151 au bâti 10 et/ou à des éléments solidaires du bâti, tels que les contre-électrodes 153-154, éventuellement par l'intermédiaire des piliers 146 du premier dispositif de transmission 14a. Ainsi, ne sont pas considérés comme des moyens élastiques « anti-pull-in » la raideur du premier dispositif de transmission 14a ou la raideur de la structure de rigidification 1511 elle-même.

Les moyens élastiques « anti-pull-in » comprennent ici les éléments d'isolation étanches 161 et, le cas échéant, les lames de torsion 162. Les éléments d'isolation étanches 161 et les lames de torsion 162 remplissent ainsi plusieurs fonctions simultanément.

Les moyens élastiques « anti-pull-in » sont reliées à la structure de rigidification 1512 là où elle est la plus rigide, à savoir au niveau des premières articulations pivot 16a. Ainsi, la raideur des moyens élastiques « anti-pull-in » n'est pas dégradée par des éléments en série de raideur trop faible. Cette raideur peut en outre être contrôlée facilement, en jouant sur les dimensions des éléments d'isolation étanches 161 et des lames de torsion 162. Les éléments d'isolation étanches 161 peuvent être délimités par gravure anisotrope d'une couche sacrificielle (par exemple en $SiO_2$) et sont réalisés dans une couche structurelle dont l'épaisseur est maitrisée. Ce type de gravure permet un bon contrôle des dimensions des éléments d'isolation étanches 161. La raideur des éléments d'isolation étanches 161 présente en conséquence une faible dispersion (principalement entre les différents systèmes électromécaniques fabriqués sur une même plaquette ou sur différentes plaquettes).

La deuxième électrode mobile 152 est avantageusement connectée au deuxième dispositif de transmission 14b de la même façon que la première électrode mobile 151 est connectée au premier dispositif de transmission 14a. Ainsi, le système électromécanique 2 comprend également des moyens élastiques « anti-pull-in » reliés à la deuxième électrode mobile 152, ces moyens élastiques comprenant de préférence les éléments d'isolation étanches 161 et, le cas échéant, les lames de torsion 162 des deuxièmes articulations pivot 16b.

Les éléments d'isolation étanches 161 et le cas échéant, les lames de torsion 162, constituent avantageusement les seuls moyens « anti-pull-in » du système électromécanique 2. Ainsi, le système électromécanique 2 est particulièrement compact.

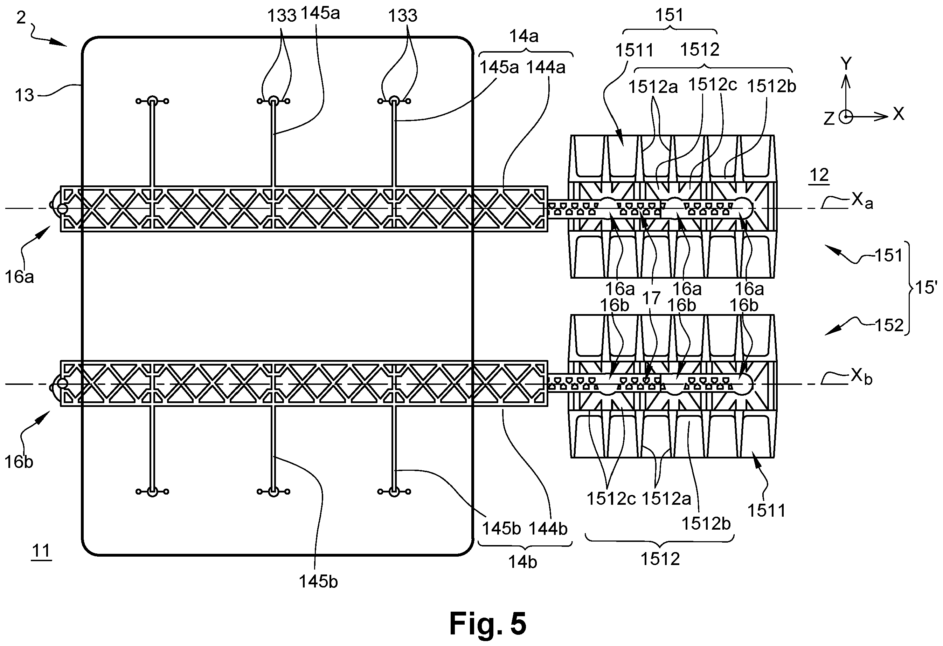

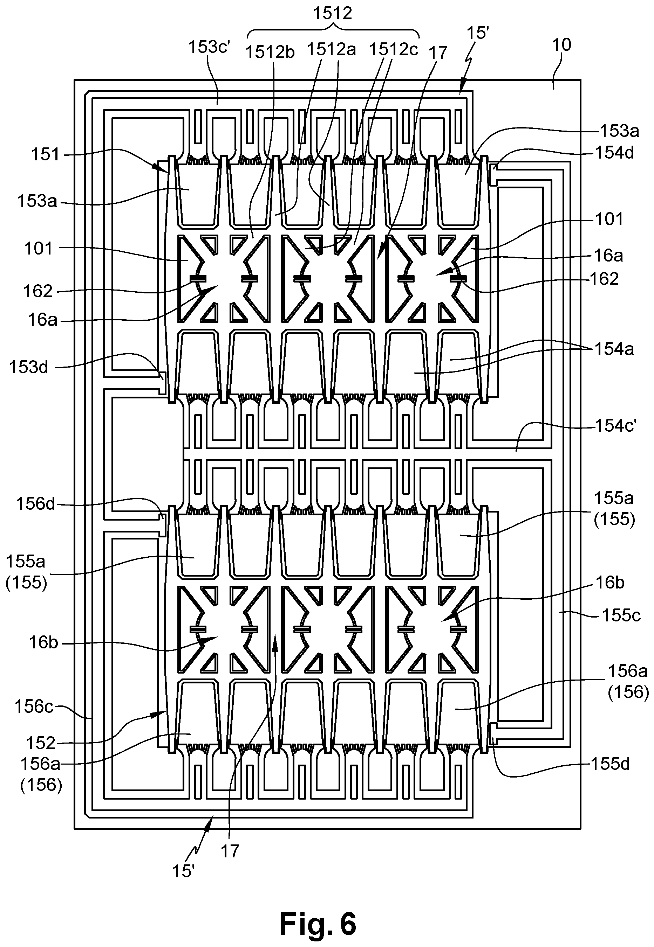

Les figures 5 et 6 représentent un deuxième mode de réalisation du système électromécanique 2. La figure 5 est une vue de dessous d'une partie du système électromécanique 2, similaire à celle de la figure 2. La membrane et la structure de rigidification du piston 13 ne sont pas représentées. La figure 6 est une vue de dessus, similaire à celle de la figure 3, montrant les moyens de détection capacitive 15' (à l'exception des portions inférieures des contre-électrodes et des membranes des électrodes mobiles sous les contre-électrodes).

Ce deuxième mode de réalisation diffère du premier mode de réalisation dans la conception des dispositifs de transmission 14a-14b et dans la conception des moyens de détection capacitive 15'. Les articulations pivot 16a-16b sont construites de la façon décrite en relation avec les figures 4A-4C (éléments d'isolation étanche et lames de torsion 162).

Les arbres de transmission 14a-14b sont ici rectilignes. Le nombre de premiers bras de transmission 144a ou de deuxièmes bras de transmission 145b est égal à 3. Ils sont de préférence régulièrement espacés.

La structure de rigidification 1512 de chaque électrode mobile 151, 152 comprend toujours des premières poutres 1512a, mais en nombre supérieur au nombre d'articulations pivot 16a, 16b servant à l'ancrage de l'électrode mobile 151, 152. Ainsi, des premières poutres 1512a ne sont pas fusionnées avec le dispositif de transmission 14a, 14b. Elles s'étendent sur les bords latéraux (selon la deuxième direction Y) de l'électrode mobile 151, 152 ou entre deux articulations pivot 16a ,16b successives.

Les deuxième poutres 1512b ne connectent plus les première poutres 1512a à leurs extrémités, mais plus près des articulations pivot 16a ,16b, par exemple à mi-distance entre l'axe de rotation Xa, Xb (passant par les lames de torsion 162 ; cf. Fig.6) et le bord longitudinal de l'électrode mobile 151, 152.

En plus d'augmenter la largeur des premières poutres 1512a au niveau des articulations pivot 16a ,16b (cf. Fig.6), ou alternativement, des poutres obliques 1512c sont ajoutées aux premières poutres 1512a fusionnées avec le dispositif de transmission 14a ,14b pour dessiner des croisillons, ce qui augmente encore la rigidité de la structure de rigidification 1512a au niveau des articulations pivot 16 (là où elle est le plus sollicitée).

L'espace 17 entre deux articulations 16a ,16b successives est occupé par une ou plusieurs premières poutres 1512a (non fusionnées avec le dispositif de transmission 14a, 14b), ce qui oblige à modifier la façon dont sont connectées les portions supérieure et inférieure des contre-électrodes.

La figure 6 montre les première et deuxième contre-électrodes 153-154 associées à la première électrode mobile 151, et des troisième et quatrième contre-électrodes 155-156 associées à la deuxième électrode mobile 152. Les troisième et quatrième contre-électrodes 155-156 sont avantageusement agencées de la même façon que les première et deuxième contre-électrodes 153-154, de préférence de la façon décrite en relation avec les figures 3, 4A-4C. En particulier, elles comprennent chacune une portion supérieure 155a, 156a, composée de différents blocs reliés électriquement entre eux, et une portion inférieure (non visible sur la figure 6) connectée à la portion supérieure.

Les différents blocs de la portion supérieure 153a de la première contre-électrode 153 sont reliés électriquement entre eux par une première piste conductrice 153c' qui s'étend à la périphérie de la première électrode mobile 151. Cette première piste conductrice 153c', dite extérieure, contourne la première électrode mobile 151 jusqu'au premier via conducteur 153d pour se connecter à la portion inférieure de la première contre-électrode 153, située de l'autre côté des premières articulations pivot 16a. De la même façon, les différents blocs de la portion supérieure 154a de la deuxième contre-électrode 154 sont reliés électriquement entre eux par une deuxième piste conductrice 154c' qui s'étend à la périphérie de la première électrode mobile 151 jusqu'au deuxième via conducteur 154b.

De préférence, la troisième contre-électrode 155 est reliée électriquement à la deuxième contre-électrode 154 de sorte à être soumise au même potentiel électrique. Les différents blocs de la portion supérieure 155a de la troisième contre-électrode 155 sont avantageusement reliés aux différents blocs de la portion supérieure 154a de la deuxième contre-électrode 154 par l'intermédiaire de la deuxième piste conductrice 154c'. Les blocs de la portion supérieure 155a de la troisième contre-électrode 155 sont avantageusement disposées en regard des blocs de la portion supérieure 154a de la deuxième contre-électrode 154. Une troisième piste conductrice 155c est par ailleurs connectée à la deuxième piste conductrice 154c' et contourne la deuxième électrode mobile 152. Cette troisième piste conductrice 155c est connectée à un troisième via conducteur 155d en contact électrique avec la portion inférieure de la troisième contre-électrode 155.

La quatrième contre-électrode 156 est de préférence reliée électriquement à la première contre-électrode 153 de sorte à être soumise au même potentiel électrique. Les différents blocs de la portion supérieure 156a de la quatrième contre-électrode 156 sont avantageusement reliés aux différents blocs de la portion supérieure 153a de la première contre-électrode 153 par l'intermédiaire de la première piste conductrice 153c' et d'une quatrième piste conductrice 156c. Cette quatrième piste conductrice 156c contourne la deuxième électrode mobile 152 et est connectée à un quatrième via conducteur 156d en contact électrique avec la portion inférieure de la quatrième contre-électrode 156.

Les connexions électriques entre les contre-électrodes 153-156 sont de préférence agencées de façon symétrique pour minimiser l'encombrement des moyens de détection capacitive 15'.

Le système électromécanique 2 décrit ci-dessus peut être fabriqué grâce aux procédés décrits dans les brevets FR3059659B1 et FR3114584B1, notamment en partant d'un empilement de couches comprenant successivement un substrat, une première couche sacrificielle et une première couche structurelle. L'empilement peut notamment être une structure multicouche de type silicium sur isolant ou SOI (« Silicon On Insulator » en anglais), communément appelée substrat SOI.

Le substrat sert notamment à réaliser, par gravure, les premiers éléments des dispositifs de transmission 14a-14b (arbres de transmission 144a-144b et bras de transmission 145a-145b), les portions inférieures des contre-électrodes 153-156 et une partie du bâti 10. Le substrat peut être en un matériau semiconducteur, par exemple le silicium.

La première couche structurelle sert notamment à réaliser la membrane 131 du piston 13, la membrane 1511 des électrodes mobiles 151-152 et les éléments d'isolation étanches 161 (membranes d'étanchéité). Elle présente une épaisseur inférieure à celle du substrat, de préférence comprise entre 100 nm et 10 $\mu$m, par exemple égale à 1 $\mu$m. Elle est de préférence constituée du même matériau que le substrat, par exemple le silicium.

La première couche sacrificielle a vocation à disparaître en partie lors de la fabrication du système électromécanique 2 pour libérer la membrane 131 du piston 13, la membrane 1511 des électrodes mobiles 151-152 et les éléments d'isolation étanches 161. Son épaisseur définit notamment la distance entre la membrane 1511 et les portions inférieures des contre-électrodes 153-156 (entrefer inférieur). Cette couche sert également de couche d'arrêt lors de la gravure du substrat, de la membrane 152a et de la deuxième couche structurelle (couche dite « MEMS » décrite ultérieurement). Les parties restantes de la première couche sacrificielle forment les joints annulaires 103, 105 et les piliers 104 inférieurs. La première couche sacrificielle peut être constituée d'un matériau diélectrique, de préférence un nitrure de silicium ou un oxyde de silicium, par exemple le dioxyde de silicium ($SiO_2$). Son épaisseur est par exemple comprise entre 100 nm et 10 $\mu$m.

Comme décrit dans les brevets précités, une deuxième couche sacrificielle est déposée sur la première couche structurelle et une deuxième couche structurelle est formée sur la deuxième couche sacrificielle, de préférence par épitaxie.

La deuxième couche structurelle est gravée pour délimiter la structure de rigidification 132 du piston 13, la structure de rigidification 1512 des électrodes mobiles 151-152, les lames de torsion 162, les portions supérieures des contre-électrodes 153-156, les premières portions 101 et la deuxième portion annulaire 102 du bâti 10. Elle est avantageusement formée du même matériau que la première couche structurelle, par exemple de silicium. L'épaisseur de la deuxième couche structurelle est de préférence comprise entre 5 $\mu$m et 50 $\mu$m, par exemple égale à 20 $\mu$m.

La structure de rigidification 1512 de chaque électrode mobile 151, 152 est fusionnée au dispositif de transmission 14a, 14b correspondant, en faisant croître la deuxième couche structurelle directement depuis le substrat, à l'emplacement des articulations pivot 16a, 16b (les première et deuxième couche sacrificielles ayant été ouvertes au préalable). Les piliers 146 des dispositifs de transmission 14a, 14b sont formés au cours de cette croissance par épitaxie.

La deuxième couche sacrificielle sert notamment de couche d'arrêt lors de la gravure de la deuxième couche structurelle. Elle est éliminée en partie pour libérer la membrane 131 du piston 13, la membrane 1511 des électrodes mobiles 151-152 et les éléments d'isolation étanches 161. Son épaisseur définit la distance entre la membrane 1511 et les portions supérieures des contre-électrodes 153-156 (entrefer supérieur). La deuxième couche sacrificielle est avantageusement formée du même matériau diélectrique que la première couche sacrificielle, par exemple un oxyde de silicium. Son épaisseur peut être comprise entre 100 nm et 10 $\mu$m.

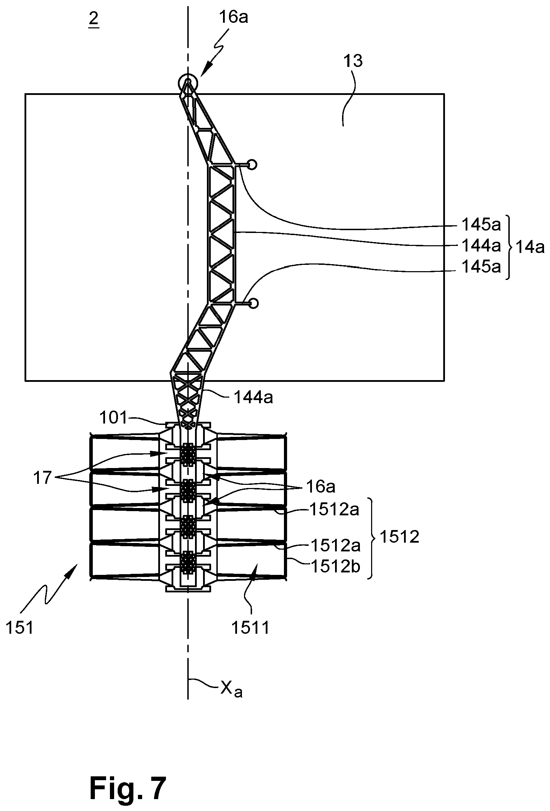

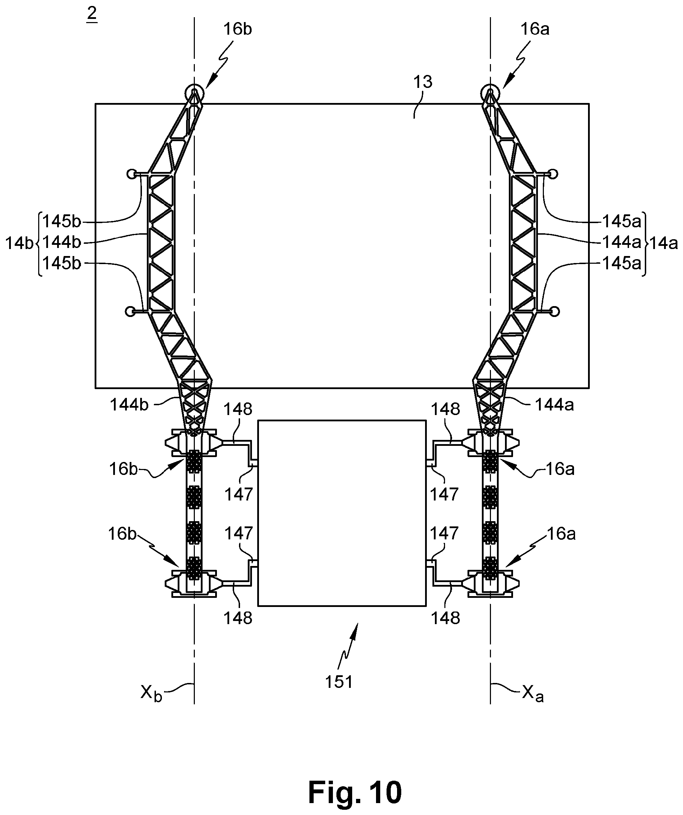

Le système électromécanique 2 ne comprend pas nécessairement les deux électrodes mobiles 151-152 et les deux dispositifs de transmission 154a-154b. Il peut comprendre une unique électrode mobile et un unique dispositif de transmission (cf. Figs.7-9), ou une unique électrode mobile et deux dispositifs de transmission reliés à cette unique électrode mobile (cf. Fig.10).

La figure 7 représente un troisième mode de réalisation dans lequel le système électromécanique 2 comprend, outre le piston 13, une unique électrode mobile 151 (par exemple de type représenté par la figure 2) et un unique dispositif de transmission 14a (par exemple de type représenté par la figure 2).

Le piston 13 est ici encore mobile en translation. Il peut être suffisamment équilibré pour être maintenu en translation par l'unique dispositif de transmission 14a. Les premières extrémités des bras de transmission 145a du dispositif de transmission 14a sont de préférence couplées au piston 13 en des points situés sur la ligne médiane du piston 13 (c.-à-d. la ligne qui sépare les deux moitiés du piston). Alternativement, le piston 13 peut être guidé en translation par d'autres moyens que l'unique dispositif de transmission 14a (notamment lorsqu'il n'est pas suffisamment bien équilibré).

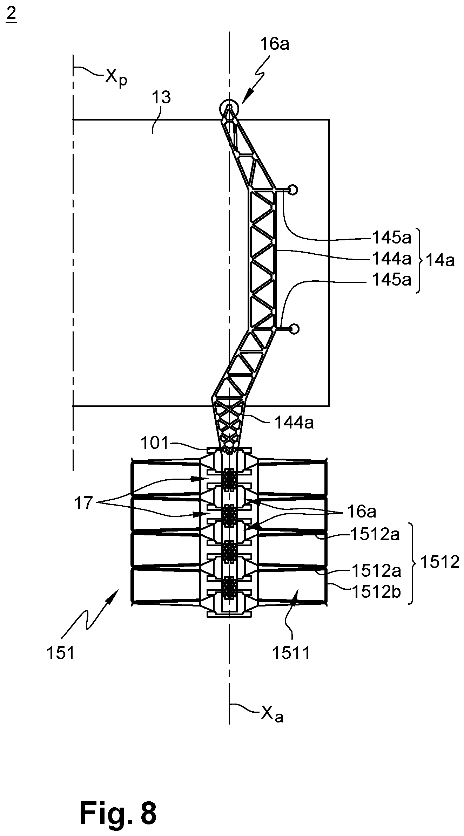

Dans un quatrième mode de réalisation représenté par la figure 8, le système électromécanique 2 comprend à nouveau qu'une seule électrode mobile 151 et qu'un seul dispositif de transmission 14a, mais le piston 13 est mobile en rotation autour d'un axe Xp (et non en translation), grâce à des articulations pivot ou charnières (non représentées) distinctes des premières articulations pivot 16a. Le mouvement de rotation du piston 13 (autour de l'axe Xp) entraîne en rotation l'arbre de transmission 144a du dispositif de transmission 14a (autour de son propre axe Xa), par l'intermédiaire des bras de transmission 145a, et l'arbre de transmission 144a met en mouvement l'électrode mobile 151 (ici en rotation autour de l'axe Xa).

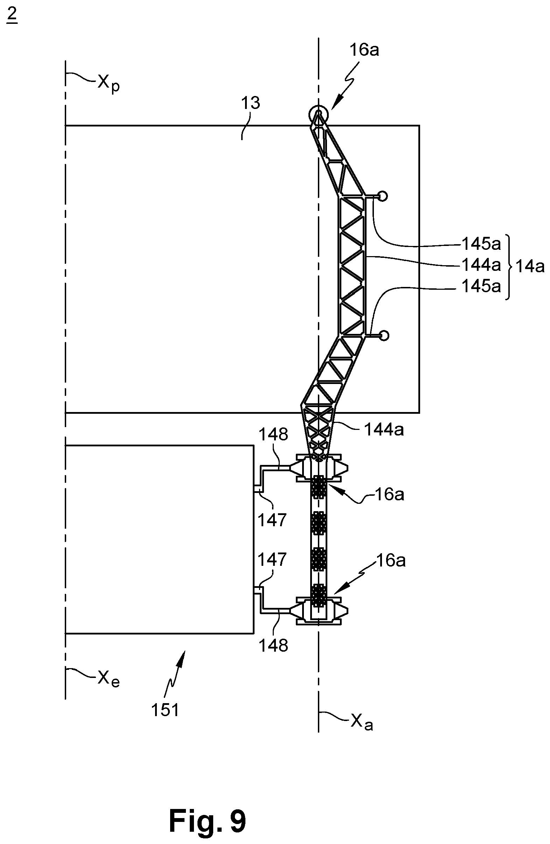

La figure 9 illustre un cinquième mode de réalisation du système électromécanique 2, qui diffère du quatrième mode de réalisation en ce que l'unique électrode mobile 151 est en rotation autour d'un axe Xe distinct de l'axe longitudinal de rotation Xa de l'arbre de transmission. Le mouvement de rotation de l'électrode mobile 151 n'est donc pas le même que le mouvement de rotation de l'arbre de transmission 144a qui n'est pas non plus le même que le mouvement de rotation du piston 13. L'axe de rotation Xp du piston 13 et l'axe de rotation Xe de l'électrode mobile 151 ne sont pas nécessairement confondus.

Ainsi, dans ce cinquième mode de réalisation (et contrairement aux précédents modes de réalisation), l'électrode mobile 151 n'est pas reliée à l'arbre de transmission 144a de manière solidaire, mais par l'intermédiaire d'éléments de couplage 147 (par exemple des lames de torsion) autorisant le passage d'une rotation à une autre rotation. Ces éléments de couplage 147 relient par exemple des poutres 148 (semblables aux premières poutres 1512a) solidaires de l'arbre de transmission 144a à la structure de rigidification de l'électrode mobile 151.

Dans un sixième mode de réalisation représenté par la figure 10, le système électromécanique 2 comprend qu'une seule électrode mobile 151 mais deux dispositifs de transmission 14a-14b (par exemple ceux représentés par la figure 2). Le piston 13 est en translation (selon Z), comme dans les premier, deuxième et troisième modes de réalisation, et l'électrode mobile 151 est en translation (selon Z), plutôt qu'en rotation. Les dispositifs de transmission 14a-14b s'étendent de part et d'autre de l'électrode mobile 151. L'électrode mobile 151 est reliée à l'arbre de transmission 144a, 144b de chacun des dispositifs de transmission 14a-14b par l'intermédiaire des éléments de couplage 147 (par exemple des lames de torsion) autorisant le passage d'une rotation à une translation et des poutres 148. Les deux arbres de transmission 144a-144b tournent dans des sens opposés, de sorte à soulever ou abaisser l'électrode mobile 151.

Le système électromécanique 2 selon l'invention n'est pas limité aux modes de réalisation décrits en relation avec les figures 2 à 10 et de nombreuses variantes et modifications du système électromécanique apparaitront à l'homme du métier.

Les arbres de transmission 144a-144b peuvent adopter d'autres géométries. Le nombre de bras de transmission 145a, 145b peut être supérieur à 3.

Le système électromécanique 2 peut également comprendre, pour chaque dispositif de transmission 14a, 14b, une ou plusieurs articulations pivot supplémentaires, non représentées par les figures, entre celle située à l'extrémité de l'arbre de transmission 144a, 144b et celles connectant l'électrode mobile 151, 152. Ces articulations pivot supplémentaires sont préférentiellement situées dans la première zone 11 et ne participent donc pas à l'étanchéité entre les deux zones.

A l'inverse, il peut ne comporter que deux articulations pivot par dispositif de transmission 14a, 14b, l'une au niveau de l'électrode mobile 151, 152, l'autre à l'extrémité de l'arbre de transmission 144a, 144b.

Le système électromécanique 2 a été décrit en prenant pour exemple un microphone à détection capacitive comprenant un piston 13 doté d'une membrane 131 soumise d'une part à la pression atmosphérique et d'autre part à une pression de référence. Le système électromécanique peut cependant former d'autres types de transducteur à détection capacitive, notamment un haut-parleur (émetteur sonore) ou un émetteur ultrasonore (qui sont des transducteurs électroacoustiques), ou encore un capteur de pression différentielle.

Dans le cas d'un capteur de pression différentielle, la première face de la membrane 131 est soumise à une première pression (pas nécessairement la pression atmosphérique) et la deuxième face de la membrane 131 est soumise à une deuxième pression, différente de la première pression. Le déplacement de la membrane 131, sous l'effet de la différence de pression, est mesuré par les moyens de détection capacitive 15'. La membrane 131 du piston est solidaire du bâti 10 de manière à être étanche et la structure de rigidification 132 du piston est absente ou réduite pour ne pas l'ancrer au bâti.

Dans le cas d'un haut-parleur ou d'un émetteur ultrasonore, des moyens d'actionnement capacitif remplacent les moyens de détection capacitive 15'. Ces moyens d'actionnement capacitif comprennent également deux électrodes mobiles et au moins une contre-électrode par électrode mobile. Les électrodes mobiles sont mises en mouvement par une force électrostatique et ce mouvement est transmis par les dispositifs de transmission 14a, 14b jusqu'au piston 13. Le mouvement de la membrane 131 du piston 13 permet d'émettre un son (ou des ultrasons).

La deuxième zone 12 peut comprendre deux chambres sous atmosphère contrôlée, l'une renfermant la première électrode mobile 151, l'autre renfermant la deuxième électrode mobile 152.

Les première et deuxième zones 11-12 isolées de manière étanche ne sont pas nécessairement soumises à des pressions différentes. La première zone 11 peut aussi être un environnement agressif et les électrodes mobiles des moyens capacitifs (de détection ou d'actionnement) sont placées dans la deuxième zone 12 pour les protéger de cette environnement agressif (en plus de réduire les frottements visqueux, et donc les bruits acoustiques).

Le système électromécanique 2 peut même être dépourvu de moyens d'étanchéité entre les première et deuxième zones 11-12 (ce qui revient à ne considérer qu'une seule zone). Plus particulièrement, les articulations pivot 16 peuvent être dépourvues d'élément d'isolation étanche 161. En effet, les lames de torsion 162 peuvent suffire pour la rotation du dispositif de transmission 14' et comme moyens élastiques « anti-pull-in ».

## Revendications

1. Système électromécanique (2) comprenant :

   - un bâti (10) ;
   - un élément mobile (13) par rapport au bâti (10) ;
   - des moyens capacitifs de mesure ou d'actionnement (15') comprenant :

     ◦ une première électrode mobile (151) par rapport au bâti (10) ; et
     ◦ au moins une électrode fixe (153, 154) par rapport au bâti (10) et séparée de la première électrode mobile (151) par un premier milieu diélectrique ;

   - un premier dispositif de transmission (14a) d'un mouvement entre l'élément mobile (13) et la première électrode mobile (151), le premier dispositif de transmission (14a) étant mobile en rotation par rapport au bâti (10) au moyen d'une pluralité de premières articulations pivot (16a) ;
   **caractérisé en ce que** le premier dispositif de transmission (14a) comprend :

     - un premier arbre de transmission (144a) présentant un premier axe longitudinal de rotation (Xa) ; et
     - une pluralité de premiers bras de transmission (145a), chacun des premiers bras de transmission (145a) comprenant une première extrémité couplée à l'élément mobile (13) et une deuxième extrémité solidaire du premier arbre de transmission (144a) ;

   et **en ce que** la première électrode mobile (151) est reliée au premier arbre de transmission (144a).

2. Système (2) selon la revendication 1, dans lequel la première électrode mobile (151) est solidaire du premier arbre de transmission (144a), d'où il résulte que la première électrode mobile (151) est montée mobile en rotation autour du premier axe longitudinal de rotation (Xa).

3. Système (2) selon l'une des revendications 1 et 2, dans lequel les moyens capacitifs de mesure ou d'actionnement (15') comprennent en outre :

   - une deuxième électrode mobile (152) par rapport au bâti (10) ; et
   - au moins une électrode additionnelle fixe (155, 156) par rapport au bâti (10) et séparée de la deuxième électrode mobile (152) par un deuxième milieu diélectrique ;
   le système comprenant en outre un deuxième dispositif de transmission (14b) d'un mouvement entre l'élément mobile (13) et la deuxième électrode mobile (152), le deuxième dispositif de transmission (14b) étant mobile en rotation par rapport au bâti (10) au moyen d'une pluralité de deuxièmes articulations pivot (16b) et comprenant :

     - un deuxième arbre de transmission (144b) présentant un deuxième axe longitudinal de rotation (Xb) ; et
     - une pluralité de deuxièmes bras de transmission (145b), chacun des deuxièmes bras de transmission (145) comprenant une première extrémité couplée à l'élément mobile (13) et une deuxième extrémité solidaire du deuxième arbre de transmission (144b) ;

système dans lequel la deuxième électrode mobile (152) est reliée au deuxième arbre de transmission (144b).

4. Système (2) selon la revendication 3, dans lequel la deuxième électrode mobile (152) est solidaire du deuxième arbre de transmission (144b), d'où il résulte que la deuxième électrode mobile (152) est montée mobile en rotation autour du deuxième axe longitudinal de rotation (Xb).

5. Système (2) selon l'une des revendications 3 et 4, dans lequel le premier axe longitudinal de rotation (Xa) est parallèle au deuxième axe longitudinal de rotation (Xb).

6. Système (2) selon l'une quelconque des revendications 3 à 5, dans lequel la première extrémité des premiers bras de transmission (145a) est couplée à une première moitié de l'élément mobile (13) et dans lequel la première extrémité des deuxièmes bras de transmission (145b) est couplée à une deuxième moitié de l'élément mobile (13).

7. Système (2) selon la revendication 6, dans lequel la première électrode mobile (151) et la deuxième électrode mobile (152) sont symétriques par rapport à un plan (P) séparant les première et deuxième moitiés de l'élément mobile (13).

8. Système (2) selon la revendication 7, dans lequel le premier dispositif de transmission (14a) et le deuxième dispositif de transmission (14b) sont symétriques par rapport au plan (P) séparant les première et deuxième moitiés de l'élément mobile (13).

9. Système (2) selon l'une quelconque des revendications 1 à 8, dans lequel au moins une des premières articulations pivot (16a) est située au niveau de la première électrode mobile (151) et une autre des premières articulations pivot (16a) est située à une extrémité du premier arbre de transmission (145a), opposée à la première électrode mobile (151).

10. Système (2) selon l'une quelconque des revendications 1 à 9, dans lequel les premiers bras de transmission (145a) s'étendent perpendiculairement au premier axe longitudinal de rotation (Xa).

11. Système (2) selon l'une quelconque des revendications 1 à 10, dans lequel la première extrémité de chaque premier bras de transmission (145a) est située à une distance $L_{pist1}$ du premier axe longitudinal de rotation (Xa) telle que :

$$\frac{1}{2} \times L_{elec1} \leq L_{pist1} \leq 2 \times L_{elec1}$$

où $L_{elec1}$ est la distance entre un bord longitudinal de la première électrode mobile (151) et le premier axe longitudinal de rotation (Xa).

12. Système (2) selon l'une quelconque des revendications 1 à 11, dans lequel au moins une partie du premier arbre de transmission (144a) située en regard de l'élément mobile (13) est ajourée.

13. Système (2) selon l'une quelconque des revendications 1 à 12, dans lequel l'élément mobile (13) est en contact avec une première zone (11) et la première électrode mobile (151) est située dans une deuxième zone (12) isolée de manière étanche de la première zone (11).

14. Système (2) selon la revendication 13, dans lequel le premier arbre de transmission (144a) et les premiers bras de transmission (145a) s'étendent dans la première zone (11) et dans lequel le premier dispositif de transmission (14a) comprend en outre des piliers (146) s'étendant en partie dans la première zone (11) et en partie dans la deuxième zone (12).

15. Système (2) selon l'une quelconque des revendications 1 à 14, dans lequel le premier arbre de transmission (144a) et les premiers bras de transmission (145a) présentent une épaisseur comprise entre 5 $\mu$m et 800 $\mu$m, de préférence entre 50 $\mu$m et 200 $\mu$m.

16. Système (2) selon l'une quelconque des revendications 1 à 15, dans lequel :

- la première électrode mobile (151) comprend une membrane (1511) et une structure de rigidification (1512) de la membrane ;

**EP 4 464 655 B1**

- la structure de rigidification (1512) de la première électrode mobile (151) est ancrée au premier dispositif de transmission (14a) au niveau d'une partie des premières articulations pivot (16a).

17. Système (2) selon la revendication 16, dans lequel la structure de rigidification (1512) de la première électrode mobile (151) comprend une pluralité de poutres (1512a) s'étendant parallèlement les unes aux autres et dans lequel une partie au moins des poutres (1512a) sont ancrées au premier dispositif de transmission (14a), chaque poutre de ladite au moins une partie étant ancrée au niveau d'une première articulation pivot (16a) correspondant à ladite poutre.

18. Système (2) selon l'une quelconque des revendications 1 à 17, dans lequel les moyens capacitifs de mesure ou d'actionnement (15') comprennent des première et deuxième électrodes fixes (153, 154) associées à la première électrode mobile (151), la première électrode mobile (151) comprenant une membrane (1511) disposée entre les première et deuxième électrodes fixes (153, 154).

**Patentansprüche**

1. Elektromechanisches System (2) mit:

   - einem Rahmen (10);
   - einem relativ zum Rahmen (10) beweglichen Element (13);
   - kapazitiven Mess- oder Betätigungsmitteln (15'), umfassend:

     ◦ eine erste Elektrode (151), die relativ zum Rahmen (10) beweglich ist; und
     ◦ mindestens eine in Bezug auf den Rahmen (10) feststehende Elektrode (153, 154), die von der ersten beweglichen Elektrode (151) durch ein erstes dielektrisches Medium getrennt ist;

   - einer ersten Vorrichtung (14a) zur Übertragung einer Bewegung zwischen dem beweglichen Element (13) und der ersten beweglichen Elektrode (151), wobei die erste Übertragungsvorrichtung (14a) mittels einer Vielzahl von ersten Schwenkgelenken (16a) relativ zum Rahmen (10) drehbar ist;
   **dadurch gekennzeichnet, dass** die erste Übertragungsvorrichtung (14a) umfasst:

     - eine erste Antriebswelle (144a) mit einer ersten Längsdrehachse (Xa); und
     - eine Vielzahl von ersten Übertragungsarmen (145a), wobei jeder der ersten Übertragungsarme (145a) ein erstes Ende, das mit dem beweglichen Element (13) verbunden ist, und ein zweites Ende, das fest mit der ersten Antriebswelle (144a) verbunden ist, umfasst;

   und dass die erste bewegliche Elektrode (151) mit der ersten Antriebswelle (144a) verbunden ist.

2. System (2) nach Anspruch 1, bei dem die erste bewegliche Elektrode (151) fest mit der ersten Antriebswelle (144a) verbunden ist, wodurch die erste bewegliche Elektrode (151) um die erste Längsdrehachse (Xa) drehbar angebracht ist.

3. System (2) nach einem der Ansprüche 1 und 2, bei dem die kapazitiven Mess- oder Betätigungsmittel (15') außerdem umfassen:

   - eine zweite in Bezug auf den Rahmen (10) bewegliche Elektrode (152); und
   - mindestens eine zusätzliche Elektrode (155, 156), die in Bezug auf den Rahmen (10) feststehend und von der zweiten beweglichen Elektrode (152) durch ein zweites dielektrisches Medium getrennt ist;
   wobei das System außerdem eine zweite Vorrichtung (14b) zur Übertragung einer Bewegung zwischen dem beweglichen Element (13) und der zweiten beweglichen Elektrode (152) umfasst, wobei die zweite Übertragungsvorrichtung (14b) mittels einer Vielzahl von zweiten Schwenkgelenken (16b) relativ zum Rahmen (10) drehbar ist und umfasst:

     - eine zweite Antriebswelle (144b) mit einer zweiten Längsdrehachse (Xb); und
     - eine Vielzahl von zweiten Übertragungsarmen (145b), wobei jeder der zweiten Übertragungsarme (145) ein erstes Ende, das mit dem beweglichen Element (13) verbunden ist, und ein zweites Ende, das fest mit der zweiten Antriebswelle (144b) verbunden ist, umfasst;

wobei die zweite bewegliche Elektrode (152) mit der zweiten Antriebswelle (144b) verbunden ist.

4. System (2) nach Anspruch 3, bei dem die zweite bewegliche Elektrode (152) fest mit der zweiten Antriebswelle (144b) verbunden ist, wodurch die zweite bewegliche Elektrode (152) um die zweite Längsdrehachse (Xb) drehbar gelagert ist.

5. System (2) nach einem der Ansprüche 3 und 4, bei dem die erste Längsdrehachse (Xa) parallel zur zweiten Längsdrehachse (Xb) verläuft.

6. System (2) nach einem der Ansprüche 3 bis 5, bei dem das erste Ende der ersten Übertragungsarme (145a) mit einer ersten Hälfte des beweglichen Elements (13) gekoppelt ist und bei dem das erste Ende der zweiten Übertragungsarme (145b) mit einer zweiten Hälfte des beweglichen Elements (13) gekoppelt ist.

7. System (2) nach Anspruch 6, bei dem die erste bewegliche Elektrode (151) und die zweite bewegliche Elektrode (152) symmetrisch zu einer Ebene (P) sind, die die erste und die zweite Hälfte des beweglichen Elements (13) trennt.

8. System (2) nach Anspruch 7, bei dem die erste Übertragungsvorrichtung (14a) und die zweite Übertragungsvorrichtung (14b) symmetrisch zu der Ebene (P) sind, die die erste und die zweite Hälfte des beweglichen Elements (13) trennt.

9. System (2) nach einem der Ansprüche 1 bis 8, bei dem mindestens eines der ersten Schwenkgelenke (16a) an der ersten beweglichen Elektrode (151) und ein weiteres der ersten Schwenkgelenke (16a) an einem Ende der ersten Antriebswelle (145a) gegenüber der ersten beweglichen Elektrode (151) angeordnet sind.

10. System (2) nach einem der Ansprüche 1 bis 9, bei dem sich die ersten Übertragungsarme (145a) senkrecht zur ersten Längsdrehachse (Xa) erstrecken.

11. System (2) nach einem der Ansprüche 1 bis 10, bei dem das erste Ende jedes ersten Übertragungsarms (145a) in einem Abstand $L_{pist1}$ von der ersten Längsdrehachse (Xa) angeordnet ist, sodass:

$$\frac{1}{2} \times L_{elec1} \leq L_{pist1} \leq 2 \times L_{elec1}$$

wobei $L_{elec}$ der Abstand zwischen einer Längskante der ersten beweglichen Elektrode (151) und der ersten Längsdrehachse (Xa) ist.

12. System (2) nach einem der Ansprüche 1 bis 11, bei dem mindestens ein Teil der ersten Antriebswelle (144a), der dem beweglichen Element (13) gegenüberliegt, durchbrochen ist.

13. System (2) nach einem der Ansprüche 1 bis 12, bei dem das bewegliche Element (13) mit einem ersten Bereich (11) in Kontakt steht und die erste bewegliche Elektrode (151) in einem zweiten Bereich (12) angeordnet ist, der gegenüber dem ersten Bereich (11) abgedichtet ist.

14. System (2) nach Anspruch 13, bei dem sich die erste Antriebswelle (144a) und die ersten Übertragungsarme (145a) in den ersten Bereich (11) erstrecken und bei dem die erste Übertragungsvorrichtung (14a) ferner Pfeiler (146) umfasst, die sich teilweise in den ersten Bereich (11) und teilweise in den zweiten Bereich (12) erstrecken.

15. System (2) nach einem der Ansprüche 1 bis 14, bei dem die erste Antriebswelle (144a) und die ersten Übertragungsarme (145a) eine Dicke zwischen 5 $\mu$m und 800 $\mu$m, vorzugsweise zwischen 50 $\mu$m und 200 $\mu$m, aufweisen.

16. System (2) nach einem der Ansprüche 1 bis 15, bei dem:

- die erste bewegliche Elektrode (151) eine Membran (1511) und eine Versteifungsstruktur (1512) für die Membran umfasst;
- die Versteifungsstruktur (1512) der ersten beweglichen Elektrode (151) an der ersten Übertragungsvorrichtung (14a) an einem Teil der ersten Schwenkgelenke (16a) verankert ist.

17. System (2) nach Anspruch 16, bei dem die Versteifungsstruktur (1512) der ersten beweglichen Elektrode (151) eine Vielzahl von Trägern (1512a) umfasst, die sich parallel zueinander erstrecken, und wobei mindestens ein Teil der Träger (1512a) an der ersten Übertragungsvorrichtung (14a) verankert ist, wobei jeder Träger des mindestens einen Teils an einem ersten Schwenkgelenk (16a) verankert ist, das dem Träger entspricht.

18. System (2) nach einem der Ansprüche 1 bis 17, bei dem die kapazitiven Mess- oder Betätigungsmittel (15') eine erste und eine zweite feste Elektrode (153, 154) umfassen, die der ersten beweglichen Elektrode (151) zugeordnet sind, wobei die erste bewegliche Elektrode (151) eine Membran (1511) umfasst, die zwischen der ersten und der zweiten feststehenden Elektrode (153, 154) angeordnet ist.

**Claims**

1. Electromechanical system (2) comprising:

   - a frame (10);
   - an element (13) movable relative to the frame (10);
   - capacitive measurement or actuation means (15') comprising:

     ○ a first electrode (151) movable relative to the frame (10); and
     ○ at least one electrode (153, 154) fixed relative to the frame (10) and separated from the first movable electrode (151) by a first dielectric medium;

   - a first transmission device (14a) for transmitting movement between the movable element (13) and the first movable electrode (151), the first transmission device (14a) being rotatably movable relative to the frame (10) by means of a plurality of first pivot hinges (16a);
   wherein the first transmission device (14a) comprises:

     - a first transmission shaft (144a) having a first longitudinal axis of rotation (Xa); and
     - a plurality of first transmission arms (145a), each of the first transmission arms (145a) comprising a first end coupled to the movable element (13) and a second end secured to the first transmission shaft (144a);

   and wherein the first movable electrode (151) is connected to the first transmission shaft (144a).

2. System (2) according to claim 1, wherein the first movable electrode (151) is secured to the first transmission shaft (144a), whereby the first movable electrode (151) is rotatably mounted about the first longitudinal axis of rotation (Xa).

3. System (2) according to one of claims 1 and 2, wherein the capacitive measurement or actuation means (15') further comprise:

   - a second electrode (152) movable relative to the frame (10); and
   - at least one additional electrode (155, 156) fixed relative to the frame (10) and separated from the second movable electrode (152) by a second dielectric medium;
   the system further comprising a second transmission device (14b) for transmitting movement between the movable element (13) and the second movable electrode (152), the second transmission device (14b) being rotatably movable relative to the frame (10) by means of a plurality of second pivot hinges (16b) and comprising:

     - a second transmission shaft (144b) having a second longitudinal axis of rotation (Xb); and
     - a plurality of second transmission arms (145b), each of the second transmission arms (145) comprising a first end coupled to the movable element (13) and a second end secured to the second transmission shaft (144b);

   in which system the second movable electrode (152) is connected to the second transmission shaft (144b).

4. System (2) according to claim 3, wherein the second movable electrode (152) is secured to the second transmission shaft (144b), whereby the second movable electrode (152) is rotatably movably mounted about the second longitudinal axis of rotation (Xb).

**5.** System (2) according to one of claims 3 and 4, wherein the first longitudinal axis of rotation (Xa) is parallel to the second longitudinal axis of rotation (Xb).

**6.** System (2) according to any of claims 3 to 5, wherein the first end of the first transmission arms (145a) is coupled to a first half of the movable element (13) and wherein the first end of the second transmission arms (145b) is coupled to a second half of the movable element (13).

**7.** System (2) according to claim 6, wherein the first movable electrode (151) and the second movable electrode (152) are symmetrical with respect to a plane (P) separating the first and second halves of the movable element (13).

**8.** System (2) according to claim 7, wherein the first transmission device (14a) and the second transmission device (14b) are symmetrical with respect to the plane (P) separating the first and second halves of the movable element (13).

**9.** System (2) according to any of claims 1 to 8, wherein at least one of the first pivot hinges (16a) is located at the first movable electrode (151) and another of the first pivot hinges (16a) is located at an end of the first transmission shaft (145a), opposite to the first movable electrode (151).

**10.** System (2) according to any of claims 1 to 9, wherein the first transmission arms (145a) extend perpendicularly to the first longitudinal axis of rotation (Xa).

**11.** System (2) according to any of claims 1 to 10, wherein the first end of each first transmission arm (145a) is located at a distance $L_{pist1}$ from the first longitudinal axis of rotation (Xa) such that:

$$\frac{1}{2} \times L_{elec1} \leq L_{pist1} \leq 2 \times L_{elec}$$

where $L_{elec1}$ is the distance between a longitudinal edge of the first movable electrode (151) and the first longitudinal axis of rotation (Xa).

**12.** System (2) according to any of claims 1 to 11, wherein at least one part of the first transmission shaft (144a) located facing the movable element (13) is perforated.

**13.** System (2) according to any of claims 1 to 12, wherein the movable element (13) is in contact with a first zone (11) and the first movable electrode (151) is located in a second zone (12) sealingly insulated from the first zone (11).

**14.** System (2) according to claim 13, wherein the first transmission shaft (144a) and the first transmission arms (145a) extend into the first zone (11) and wherein the first transmission device (14a) further comprises pillars (146) extending partly into the first zone (11) and partly into the second zone (12).

**15.** System (2) according to any of claims 1 to 14, wherein the first transmission shaft (144a) and the first transmission arms (145a) have a thickness between 5 $\mu$m and 800 $\mu$m, preferably between 50 $\mu$m and 200 $\mu$m.

**16.** System (2) according to any of claims 1 to 15, wherein:

- the first movable electrode (151) comprises a membrane (1511) and a membrane rigidifying structure (1512);
- the rigidifying structure (1512) of the first movable electrode (151) is anchored to the first transmission device (14a) at a part of the first pivot hinges (16a).

**17.** System (2) according to claim 16, wherein the rigidifying structure (1512) of the first movable electrode (151) comprises a plurality of beams (1512a) extending in parallel to each other and wherein at least one part of the beams (1512a) are anchored to the first transmission device (14a), each beam of said at least one part being anchored to a first pivot hinge (16a) corresponding to said beam.

**18.** System (2) according to any of claims 1 to 17, wherein the capacitive measurement or actuation means (15') comprise first and second fixed electrodes (153, 154) associated with the first movable electrode (151), the first movable electrode (151) comprising a membrane (1511) disposed between the first and second fixed electrodes (153, 154).

**Fig. 1**

**Fig. 2**

EP 4 464 655 B1

**Fig. 3**

## Fig. 4A

## Fig. 4B

## Fig. 4C

Fig. 5

**Fig. 6**

**Fig. 7**

**Fig. 8**

**Fig. 9**

**Fig. 10**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2008078182 A
- FR 3114584 B1
- FR 3059659 B1